# EUROPEAN PATENT SPECIFICATION

(11) **EP 1 767 993 B1**
(45) Date of publication and mention of the grant of the patent: **24.12.2008**
(21) Application number: 06019979.1
(22) Date of filing: 25.09.2006
(51) Int. Cl.: G03F 7/039

(54) **Positive photosensitive composition and pattern forming method using the same**
Positive lichtempfindliche Zusammensetzung und Verfahren zur Strukturformung damit
Composition photosensible positive et procédé de formation de motif utilisant celle-ci

(30) Priority: 26.09.2005 JP 2005278297
(43) Date of publication of application: 28.03.2007
(73) Proprietor: FUJIFILM Corporation, Minato-ku Tokyo (JP)
(72) Inventor: Nishiyama, Fumiyuki, Yoshida-cho, Haibara-gun Shizuoka (JP); Kodama, Kunihiko, Yoshida-cho, Haibara-gun Shizuoka (JP)
(74) Representative: HOFFMANN EITLE

(56) References cited:
- US-A1- 2005 147 915
- US-A1- 2005 208 419

## Description

### FIELD OF THE INVENTION

The present invention relates to a positive photosensitive composition for use in the production process of a semiconductor such as IC, in the production of a circuit substrate of liquid crystal, thermal head or the like or in other photofabrication processes, and a pattern forming method using the same. More specifically, the present invention relates to a positive photosensitive composition suitable for the processing where an exposure light source of emitting a far ultraviolet ray or the like of 250 nm or less, preferably 220 nm or less, or an irradiation source utilizing an electron beam or the like is used, and a pattern forming method using the same.

### BACKGROUND OF THE INVENTION

A chemical amplification-type photosensitive composition is a pattern forming material capable of forming a pattern on a substrate by producing an acid in the exposed area upon irradiation with actinic rays or radiation, such as far ultraviolet ray, and through a reaction using this acid as the catalyst, changing the solubility in a developer between the area irradiated with actinic rays or radiation and the non-irradiated area.

In the case of using a KrF excimer laser as the exposure light source, a resin having small absorption in the region of 248 nm and having a basic skeleton of poly(hydroxystyrene) is predominantly used as the main component, and this is an excellent system capable of forming a good pattern with high sensitivity and high resolution as compared with the conventional naphthoquinonediazide/novolak resin system.

In the case where a light source of emitting light at a shorter wavelength, for example, an ArF excimer laser (193 nm), is used as the exposure light source, a satisfactory pattern cannot be formed even by the above-described chemical amplification system because the compound having an aromatic group substantially has large absorption in the region of 193 nm.

In order to solve this problem, a resist containing a resin having an alicyclic hydrocarbon structure has been developed as the resist for use with an ArF excimer laser. JP-A-9-73173 (the term "JP-A" as used herein means an "unexamined published Japanese patent application") describes a resist composition containing an acid-decomposable resin having an adamantane structure. However, along with miniaturization of a pattern, the thickness of the resist film needs to be reduced and dry etching resistance is required of the resist film. U.S. Patent Application Publication No. 2005/0074690A describes a resin containing a repeating unit having a diamantane structure.

The dry etching resistance is correlated with the carbon density of the resin and may be improved by increasing the carbon density, but the resin becomes hydrophobic due to increase in the carbon density and this gives rise to deterioration or the like of the development defect performance or pattern forming ability. In order to solve this problem, JP-A-2001-215704 discloses that a resin having a certain high-polarity polymerization unit is effective for the improvement of wettability to an alkali developer. However, such a technique has a problem in that at the formation of a fine pattern having a line width of 100 nm or less, the finish size with the same exposure amount differs between an exposure mask having a small light transmitting region (Dark Field Mask) and an exposure mask having a large light transmitting region (Bright Field Mask) (hereinafter, this problem is sometimes referred to as a "Dark·Bright difference"), despite excellent resolving performance. For attaining the same finish size in both regions, not only the structure of the specific repeating unit but also the formulation design including a combination of a surfactant as another resist constituent component and a photoacid generator as the photosensitive component are important.

### SUMMARY OF THE INVENTION

Accordingly, an object of the present invention is to provide a positive photosensitive composition ensuring that even in the formation of a fine pattern of 100 nm or less, the difference in the finish size between the Dark Field Mask and the Bright Field Mask with the same size and the same exposure amount (Dark·Bright difference) is reduced, and a pattern forming method using the same.

It has been found that the above-described object can be attained by the following constitutions.
(1) A positive photosensitive composition comprising:
   (A) a resin which comprises (Ba) a repeating unit having a diamantane structure and decomposes under the action of an acid to increase the solubility in an alkali developer,
   (B) a compound capable of generating an acid upon irradiation with actinic rays or radiation,
   (C) a compound represented by formula (1), and
   (D) a solvent; 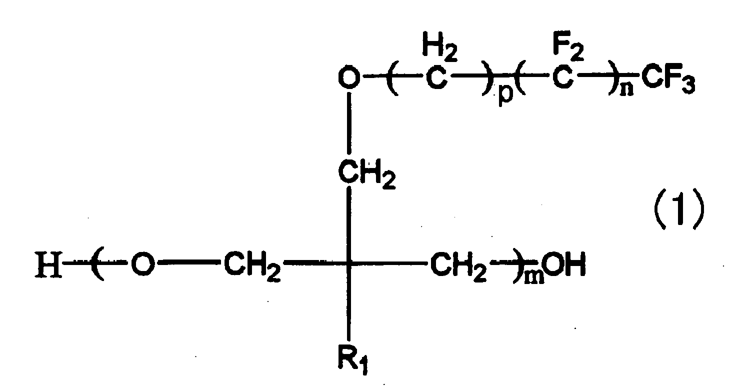
   wherein R₁ represents a hydrogen atom or an alkyl group,
   m represents an integer of 1 to 30,
   n represents an integer of 0 to 3, and
   p represents an integer of 0 to 5.
(2) The positive photosensitive composition as described in (1) above, wherein the resin as the component (A) has a weight average molecular weight of 3,000 to 30,000 and a dispersity of 1.1 to 3.0.
(3) The positive photosensitive composition as described in (1) or (2) above, wherein the resin as the component (A) is a resin containing a repeating unit having an adamantane structure.
(4) The positive photosensitive composition as described in any one of (1) to (3) above, wherein the resin as the component (A) is a resin further containing a non-acid-decomposable repeating unit.
(5) The positive photosensitive composition as described in any one of (1) to (4) above, which contains an alkylene glycol monoalkyl ether carboxylate as the (D) solvent.
(6) The positive photosensitive composition as described in (5) above, wherein an alkylene glycol monoalkyl ether carboxylate and another solvent are contained as the (D) solvent, and the another solvent is at least one kind of solvent selected from solvents having at least one functional group selected from the group consisting of a hydroxyl group, a ketone group, a lactone group, an ester group, and ether group and a carbonate group.
(7) The positive photosensitive composition as described in (6) above, wherein propylene glycol monomethyl ether carboxylate and another solvent are contained as the (D) solvent, and the another solvent is at least one kind of solvent selected from propylene glycol monomethyl ether, cyclohexanone, γ-butyrolactone, butyl acetate and ethyl lactate.
(8) The positive photosensitive composition as described in any one of (1) to (7) above, wherein the resin as the component (A) is a resin synthesized by dropping polymerization.
(9) A pattern forming method comprising steps of forming a photosensitive film from the positive photosensitive composition described in any one of (1) to (8) above, and exposing and developing the photosensitive film.

The positive photosensitive composition of the present invention ensures that even in the formation of a fine pattern of 100 nm or less, the Dark·Bright difference is improved and a good pattern can be stably obtained without depending on the pattern coverage.

### BRIEF DESCRIPTION OF THE DRAWINGS

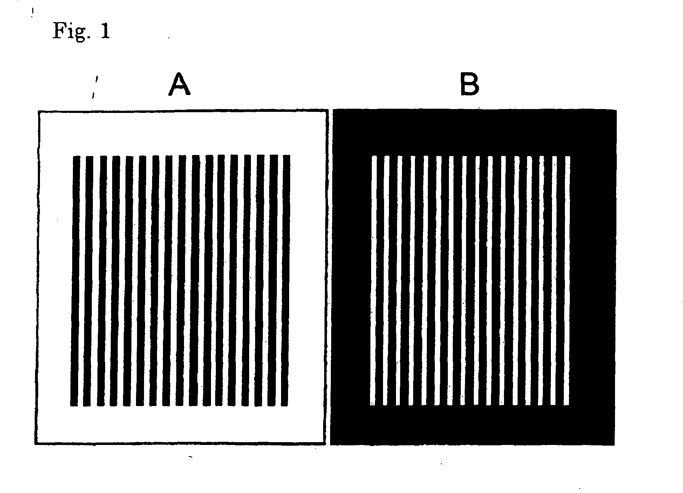

Fig. 1 is a view showing the Bright Field Mask and Dark Field Mask used in Examples.

### DETAILED DESCRIPTION OF THE INVENTION

The best mode for carrying out the present invention is described below.

### [1] (A) Resin which comprises (Aa) a repeating unit having a diamantane structure and decomposes under the action of an acid to increase the solubility in an alkali developer (sometimes referred to as a "resin as the component (A)")

The resin as the component (A) is a resin comprising at least one kind of a group capable of decomposing under the action of an acid to increase the solubility in an alkali developer (hereinafter sometimes referred to as an "acid-decomposable group"). The acid-decomposable group may be contained in the (Aa) repeating unit having a diamantane structure or in another repeating unit.

Examples of the acid-decomposable group include a group where the hydrogen atom of an alkali-soluble group such as carboxyl group and hydroxyl group is protected by a group capable of desorbing under the action of an acid.

Examples of the group capable of desorbing under the action of an acid include -C(R₃₆) (R₃₇) (R₃₈), -C(R₃₆) (R₃₇) (OR₃₉) and -C(R₀₁)(R₀₂)(OR₃₉).

In the formulae, R₃₆ to R₃₉ each independently represents an alkyl group, a cycloalkyl group, an aryl group, an aralkyl group or an alkenyl group, and R₃₆ and R₃₇ may combine with each other to form a ring.

R₀₁ and R₀₂ each independently represents a hydrogen atom, an alkyl group, a cycloalkyl group, an aryl group, an aralkyl group or an alkenyl group.

The (Aa) repeating unit having an adamantane structure is preferably a repeating unit selected from the followings:
(Aa-1) a repeating unit containing an acid-decomposable group and having a diamantane structure in a group capable of desorbing under the action of an acid, which is present in the acid-decomposable group; and
(Aa-2) a repeating unit having a diamantane structure and insusceptible to the action of an acid or an alkali.

The repeating units (Aa-1) and (Aa-2) each may have a substituent, and preferred examples of the substituent include an alkyl group and a polar functional group. The repeating units (Aa-1) and (Aa-2) are preferably a repeating unit having a structure where a polar group is substituted on the diamantane. Examples of the polar functional include a hydroxyl group, a carboxyl group, a cyano group, an amide group, a sulfonamide group and a sulfonylimide group, with a hydroxyl group being preferred.

### (Aa-1) Repeating unit containing an acid-decomposable group and having a diamantane structure in a group capable of desorbing under the action of an acid, which is present in the acid-decomposable group

The group having a diamantane structure and desorbing under the action of an acid is preferably a group represented by any one of the following formulae (DpI) to (DpV), and the repeating unit containing an acid-decomposable group and having a diamantane structure in the group capable of desorbing under the action of an acid, which is present in the acid-decomposable group, is preferably a repeating unit containing an acid-decomposable group where the hydrogen atom of an alkali-soluble group is protected by a group represented by any one of formulae (DpI) to (DpV).

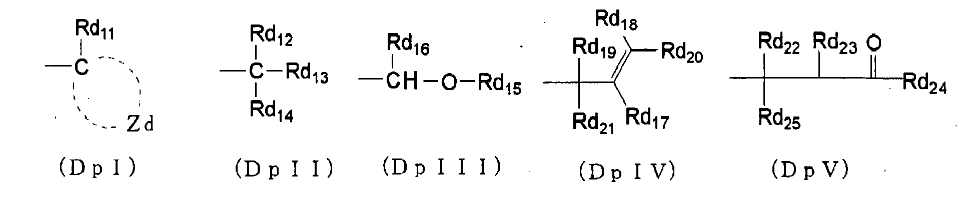

In formulae (DpI) to (DpV), Rd₁₁ represents a methyl group, an ethyl group, an n-propyl group, an isopropyl group, an n-butyl group, an isobutyl group or a sec-butyl group, and Z represents an atomic group necessary for forming a diamantyl group together with the carbon atom.

Rd₁₂ to Rd₁₆ each independently represents a linear or branched alkyl group having a carbon number of 1 to 4 or a cycloalkyl group, provided that at least one of Rd₁₂ to Rd₁₄ or either one of Rd₁₅ and Rd₁₆ represents a diamantyl group or a diamantyl group-containing group (preferably an alkyl group containing a diamantyl group and having a carbon number of 1 to 5).

Rd₁₇ to Rd₂₁ each independently represents a hydrogen atom, a linear or branched alkyl group having a carbon number of 1 to 4 or a cycloalkyl group, provided that at least one of Rd₁₇ to Rd₂₁ represents a diamantyl group or a diamantyl group-containing group (preferably an alkyl group containing a diamantyl group and having a carbon number of 1 to 5). Also, either one of Rd₁₉ and Rd₂₁ represents a linear or branched alkyl group having a carbon number of 1 to 4 or a cycloalkyl group.

Rd₂₂ to Rd₂₅ each independently represents a hydrogen atom, a linear or branched alkyl group having a carbon number of 1 to 4 or an alicyclic hydrocarbon group, provided that at least one of Rd₂₂ to Rd₂₅ represents a diamantyl group or a diamantyl group-containing group (preferably an alkyl group containing a diamantyl group and having a carbon number of 1 to 5). Rd₂₃ and Rd₂₄ may combine with each other to form a ring.

The repeating unit containing an acid-decomposable group where the hydrogen atom of an alkali-soluble group is protected by a group represented by any one of formulae (DpI) to (DpV), is preferably a repeating unit represented by the following formula (DpA):

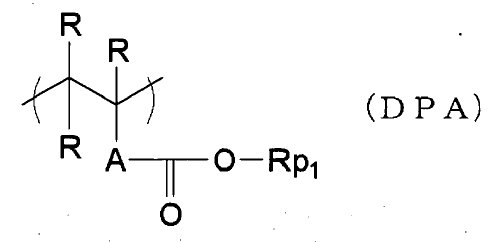

In formula (DPA), R represents a hydrogen atom, a halogen atom, a linear or branched alkyl group having a carbon number of 1 to 4, a carboxyl group, an alkoxycarbonyl group or a hydroxymethyl group, and the plurality of R's may be the same or different.

A represents a single bond, or sole group or a combination of two or more groups, selected from the group consisting of an alkylene group, an ether group, a thioether group, a carbonyl group, an ester group, an amido group, a sulfonamido group, a urethane group and a urea group. A is preferably a single bond.

Rp₁ represents any one group of formulae (DpI) to (DpV).

Specific preferred examples of the repeating unit (Aa-1) are set forth below, but the present invention is not limited thereto.

(In the formulae, Rx is H, CH₃, CF₃ or CH₂OH, and Rxa and Rxa each is an alkyl group having a carbon number of 1 to 4.)

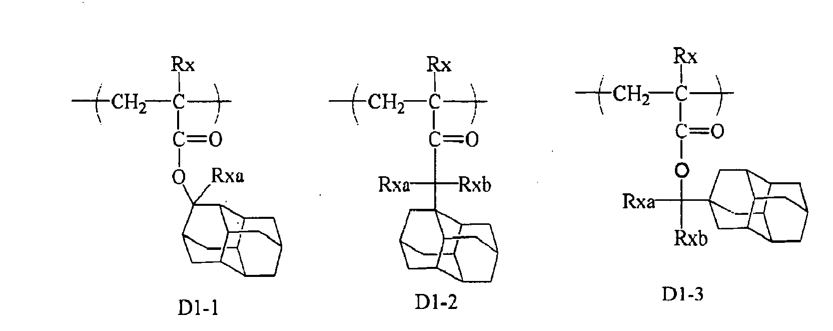

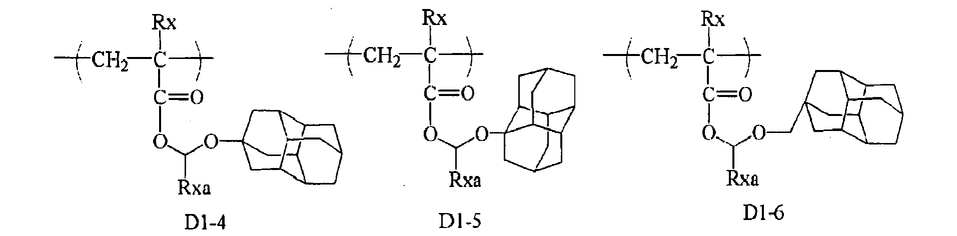

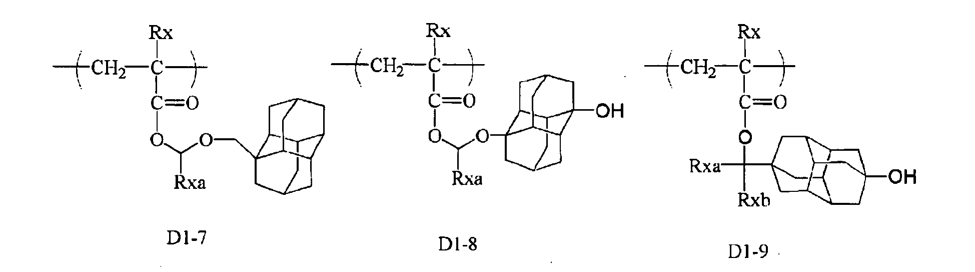

In specific examples above, Rx represents H, CH₃, CF₃ or CH₂OH, and Rxa and Rxb each independently represents a linear or branched alkyl group having a carbon number of 1 to 6 or a cycloalkyl group having a carbon number of 3 to 6. The alkyl chain or cycloalkyl chain may contain a heteroatom such as oxygen and sulfur.

### (Aa-2) Repeating unit having a diamantane structure and insusceptible to the action of an acid or an alkali

The term "insusceptible to the action of an acid or an alkali" as used in the present invention means that the repeating unit exhibits no or very low reactivity for the action of an acid or an alkali in the process where the positive photosensitive composition of the present invention is usually used, and contains substantially no group contributing to the image formation utilizing the action of an acid or an alkali. For example, in the case of positive chemical amplification photosensitivity, an acid generator is decomposed in the exposed area at the exposure step to generate an acid, and the acid decomposes an acid-decomposable group-containing resin at the post-heating step to release an alkali-soluble group, whereby only the exposed area becomes alkali-developable and the exposed area is selectively developed at the alkali development step to form a pattern. The repeating unit (Aa-2) exhibits no or very low reactivity for the action of an acid or an alkali in this exposure, post-heating or development step and contains substantially no group contributing to the change in the dissolution contrast.

The repeating unit (Aa-2) is preferably represented by the following formula (DPB):

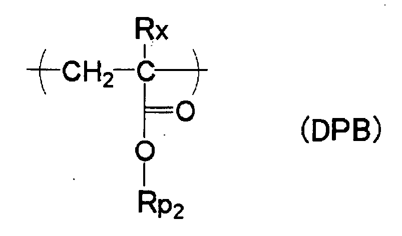

In formula (DPB), Rx represents H, CH₃, CF₃ or CH₂OH.

Rₚ₂ represents a diamantyl group or a diamantyl group-containing group (preferably a diamantyl group-containing alkyl group having a carbon number of 1 to 5), which does not desorb from the oxygen atom under the action of an acid or an alkali. Examples of the group which does not desorb from the oxygen atom under the action of an acid or an alkali include a group having a primary or secondary ester bond. Furthermore, a tertiary ester structure connected to the tertiary carbon atom at the 1-, 4-, 6- or 9-position of a diamantyl group through an ester bond as in D2-1, D2-2 and D2-5 to D2-14 shown below exhibits no acid-decomposability and does not substantially contribute to the image formation utilizing the action of an acid, and this is also a preferred structure.

Specific preferred examples of the repeating unit (Aa-2) are set forth below, but the present invention is not limited thereto.

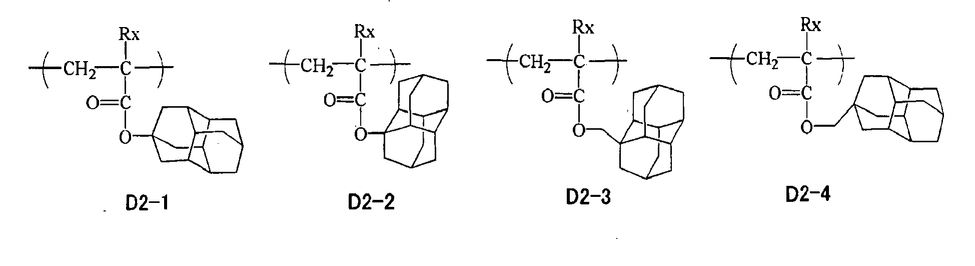

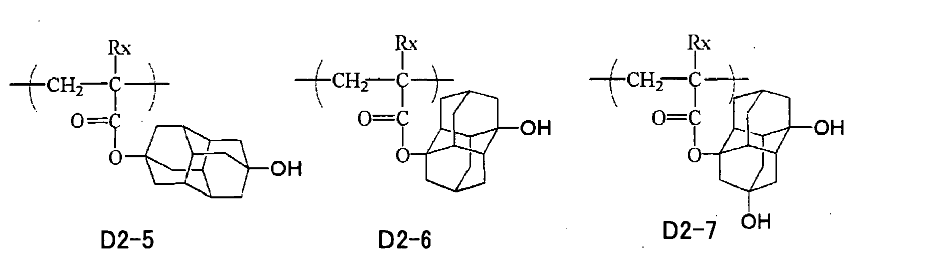

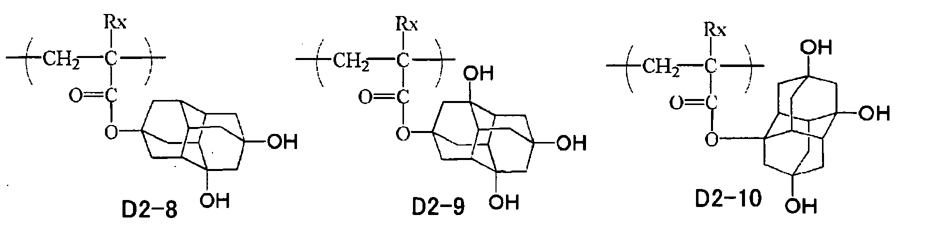

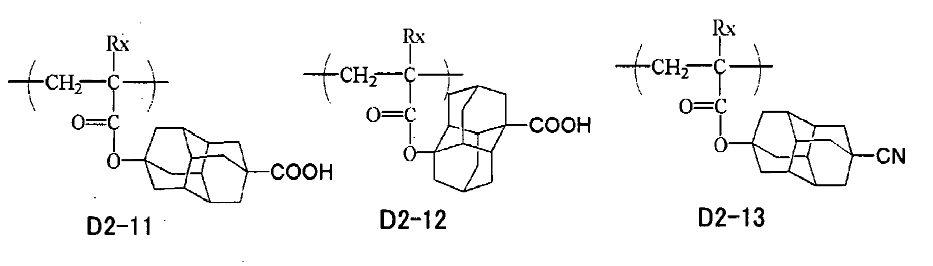

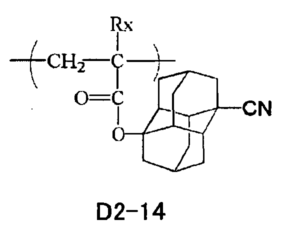

In specific examples above, Rx represents H, CH₃, CF₃ or CH₂OH.

In the case where the repeating unit (Aa) having a diamantane structure does not contain an acid-decomposable group, the resin as the component (A) contains an acid-decomposable group in another repeating unit. The resin as the component (A) may contain a repeating unit (Aa-1) containing an acid-decomposable group and having a diamantane structure in a group capable of desorbing under the action of an acid, which is present in the acid-decomposable group, and another repeating unit having an acid-decomposable group. The group preferred as the acid-decomposable group is a group where the hydrogen atom of a -COOH group or a -OH group is substituted by a group capable of desorbing under the action of an acid. In the present invention, the acid-decomposable group is preferably an acetal group or a tertiary ester group.

In the case where the acid-decomposable group is bonded as a side chain, the matrix resin is an alkali-soluble resin having an -OH or -COOH group in the side chain. Examples thereof include an alkali-soluble resin which is described later.

The alkali dissolution rate of such an alkali-soluble resin is preferably 170 A/sec (17 nm/sec) or more, more preferably 330 A/sec (33 nm/sec) or more (A is angstrom), as measured (at 23°C) with 0.261 N tetramethylammonium hydroxide (TMAH).

From this standpoint, preferred alkali-soluble resins are an alkali-soluble resin having a hydroxystyrene structural unit, for example, an o-, m- or p-poly(hydroxystyrene) including a copolymer thereof, a hydrogenated poly(hydroxystyrene), a halogen- or alkylsubstituted poly(hydroxystyrene), a partially O-alkylated or O-acylated poly(hydroxystyrene), a styrene-hydroxystyrene copolymer, an α-methylstyrene-hydroxystyrene copolymer and a hydrogenated novolak resin; and an alkali-soluble resin having a carboxyl group-containing repeating unit such as (meth)acrylic acid and norbornenecarboxylic acid.

The resin as the component (A) may be obtained, as disclosed, for example, in European Patent No. 254853, JP-A-2-25850, JP-A-3-223860 and JP-A-4-251259, by reacting a precursor of an acid-decomposable group with an alkali-soluble resin or by copolymerizing an alkali-soluble resin monomer having bonded thereto an acid-decomposable group with various monomers.

The another repeating unit containing an acid-decomposable group is preferably at least one member selected from the repeating units where the alkali-soluble group is protected by a chain tertiary alkyl group such as tert-butyl group and tert-pentyl group or by a group having an alicyclic hydrocarbon-containing partial structure represented by any one of the following formulae (pI) to (pV).

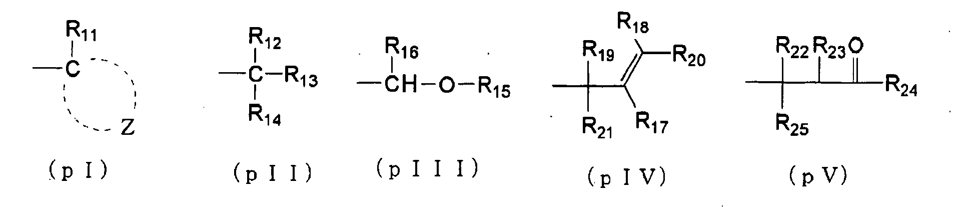

In formulae (pI) to (pV), R₁₁ represents a methyl group, an ethyl group, an n-propyl group, an isopropyl group, an n-butyl group, an isobutyl group or a sec-butyl group. Z represents an atomic group necessary for forming a cycloalkyl group together with the carbon atom.

R₁₂ to R₁₆ each independently represents a linear or branched alkyl group having a carbon number of 1 to 4 or a cycloalkyl group, provided that at least one of R₁₂ to R₁₄ or either one of R₁₅ and R₁₆ represents a cycloalkyl group.

R₁₇ to R₂₁ each independently represents a hydrogen atom, a linear or branched alkyl group having a carbon number of 1 to 4 or a cycloalkyl group, provided that at least one of R₁₇ to R₂₁ represents a cycloalkyl group and that either one of R₁₉ and R₂₁ represents a linear or branched alkyl group having a carbon number of 1 to 4 or a cycloalkyl group.

R₂₂ to R₂₅ each independently represents a hydrogen atom, a linear or branched alkyl group having a carbon number of 1 to 4 or a cycloalkyl group, provided that at least one of R₂₂ to R₂₅ represents a cycloalkyl group. R₂₃ and R₂₄ may combine with each other to form a ring.

In formulae (pI) to (pV), the alkyl group as R₁₂ to R₂₅ is a linear or branched alkyl group having from 1 to 4 carbon atoms, and examples thereof include a methyl group, an ethyl group and a propyl group.

The cycloalkyl group of R₁₂ to R₂₅ and the cycloalkyl group formed by Z together with the carbon atom may be monocyclic or polycyclic. Specifically, the cycloalkyl group includes a group having a carbon number of 5 or more and having a monocyclo, bicyclo, tricyclo or tetracyclo structure or the like. The carbon number thereof is preferably from 6 to 30, more preferably from 7 to 25. These cycloalkyl groups each may have a substituent.

Preferred examples of the cycloalkyl group include an adamantyl group, a noradamantyl group, a decalin residue, a tricyclodecanyl group, a tetracyclododecanyl group, a norbornyl group, a cedrol group, a cyclopentyl group, a cyclohexyl group, a cycloheptyl group, a cyclooctyl group, a cyclodecanyl group and a cyclododecanyl group. Among these, more preferred are an adamantyl group, a norbornyl group, a cyclohexyl group, a cyclopentyl group, a tetracyclododecanyl group and a tricyclodecanyl group.

Examples of the substituent which these alkyl group and cycloalkyl group may further have include an alkyl group (having a carbon number of 1 to 4), a halogen atom, a hydroxyl group, an alkoxy group (having a carbon number of 1 to 4), a carboxyl group and an alkoxycarbonyl group (having a carbon number of 2 to 6). Examples of the substituent which these alkyl group, alkoxy group, alkoxycarbonyl group and the like may further have include a hydroxyl group, a halogen atom and an alkoxy group.

The structures represented by formulae (pI) to (pV) each can be used for the protection of an alkali-soluble group in the resin. Specific examples thereof include a structure where the hydrogen atom of a carboxylic acid group, a sulfonic acid group, a phenol group or a thiol group is replaced by the structure represented by any one of formulae (pI) to (pV). A structure where the hydrogen atom of a carboxylic acid group or a sulfonic acid group is replaced by the structure represented by any one of formulae (pI) to (pV), is preferred.

The repeating unit having an alkali-soluble group protected by the structure represented by any one of formulae (pI) to (pV) is preferably a repeating unit represented by the following formula (pA):

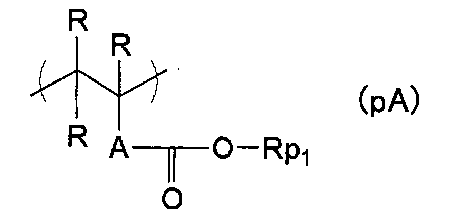

In this formula, R represents a hydrogen atom, a halogen atom or a linear or branched alkyl group having a carbon number of 1 to 4, and a plurality of R's may be the same or different.

A represents a single bond, or sole group or a combination of two or more groups, selected from the group consisting of an alkylene group, an ether group, a thioether group, a carbonyl group, an ester group, an amido group, a sulfonamido group, a urethane group and a urea group. A is preferably a single bond.

Rₚ₁ represents any one group of formulae (pI) to (pV).

The repeating unit represented by formula (pA) is preferably a repeating unit comprising 2-alkyl-2-adamantyl (meth)acrylate, 2-(1-adamantyl)-2-propyl (meth)acrylate, 1-alkyl-1-cyclopentyl (meth)acrylate or 1-alkyl-1-cyclohexyl (meth)acrylate.

Specific examples of the repeating unit represented by formula (pA) are set forth below.

(In the formulae, Rx represents H, CH₃, CF₃ or CH₂OH, and Rxa and Rxa each independently represents an alkyl group having a carbon number of 1 to 4.)

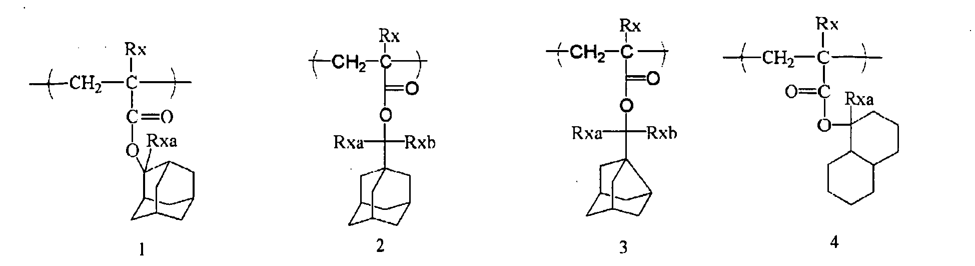

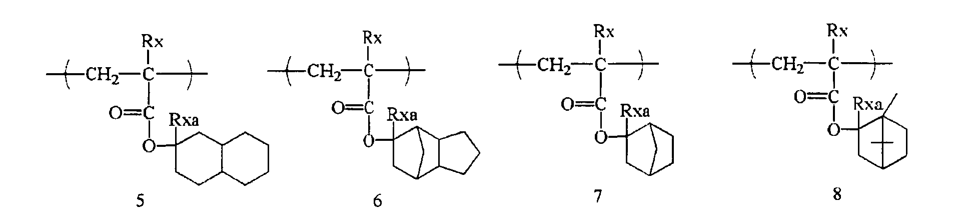

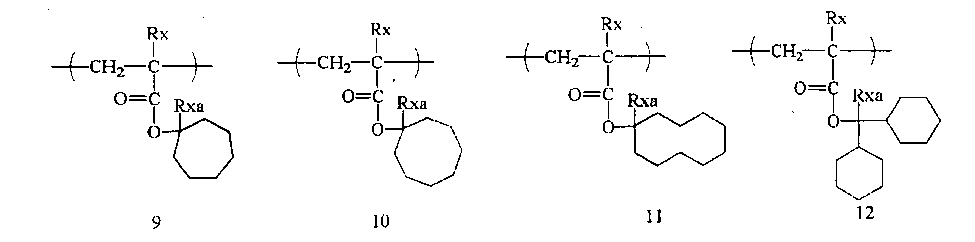

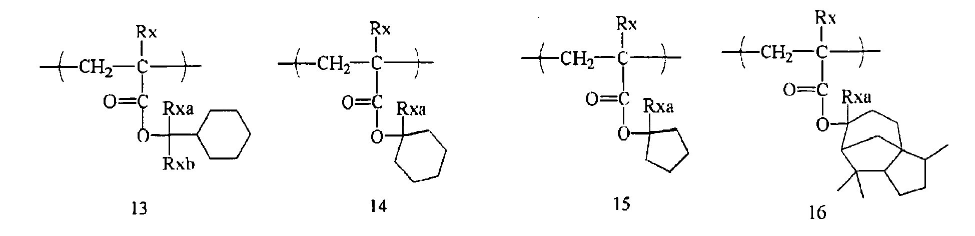

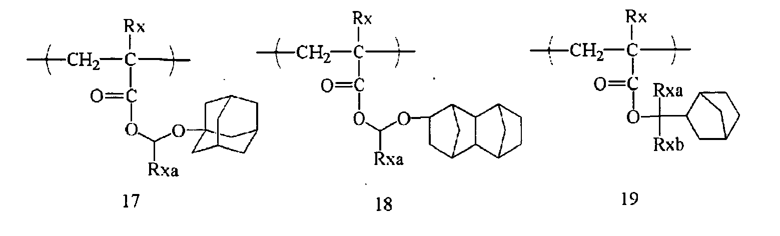

The resin as the component (A) preferably further contains a non-acid-decomposable repeating unit.

The non-acid-decomposable repeating unit includes a non-acid-decomposable repeating unit which is, for example, the following repeating unit having a lactone group or having an alicyclic hydrocarbon structure substituted by a polar group. The term "non-acid-decomposable" as used herein means that the repeating unit exhibits no or very low reactivity for the action of an acid in the process where the positive photosensitive composition of the present invention is usually employed, and contains substantially no group contributing to the image formation utilizing an acid.

The resin as the component (A) preferably contains a repeating unit having a lactone group. As for the lactone group, any group may be used as long as it has a lactone structure, but a group having a 5-, 6- or 7-membered ring lactone structure is preferred. The 5-, 6- or 7-membered ring lactone structure is preferably condensed with another ring structure in the form of forming a bicyclo or spiro structure. The repeating unit is more preferably a repeating unit containing a group having a lactone structure represented by any one of the following formulae (LC1-1) to (LC1-16). The group having a lactone structure may be bonded directly to the main chain. The lactone group is preferably connected to the polymer main chain through a non-acid-decomposable bond. That is, the repeating unit having a lactone group is preferably a non-acid-decomposable repeating unit. The non-acid-decomposable bond is preferably a primary or secondary ester bond. The primary or secondary ester bond exhibits no or very low reactivity for the action of an acid in the process where the positive photosensitive composition of the present invention is usually used.

Preferred lactone structures are (LC1-1), (LC1-4), (LC1-5), (LC1-6), (LC1-13) and (LC1-14). By virtue of using a specific lactone structure, the line edge roughness and the development defect are improved.

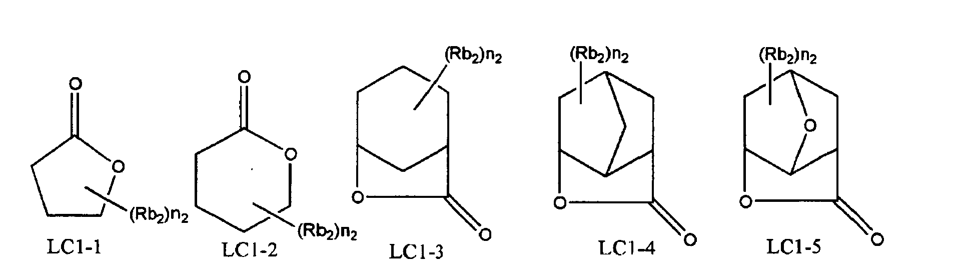

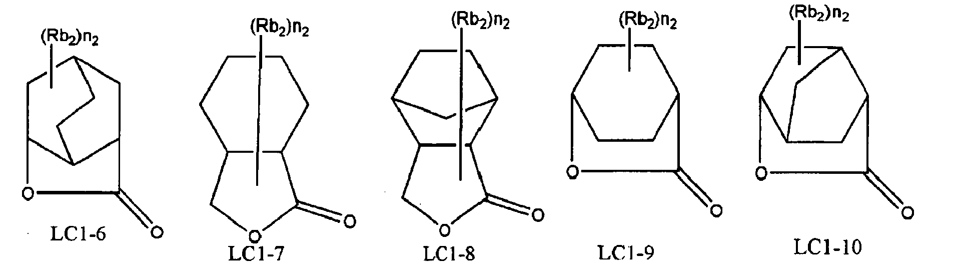

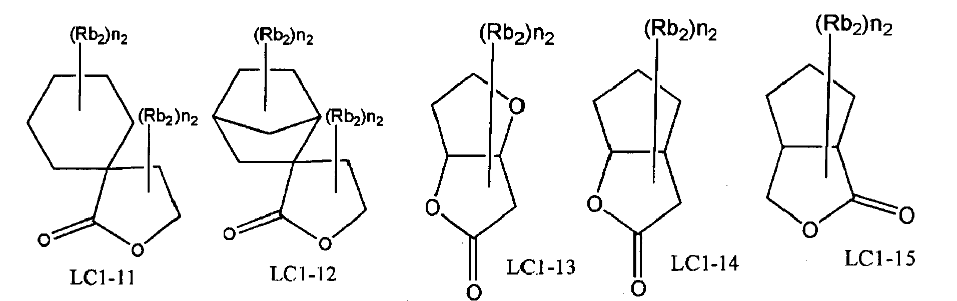

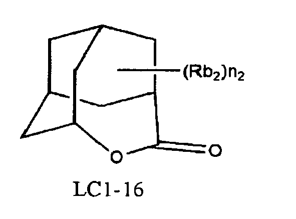

The lactone structure moiety may or may not have a substituent (Rb₂). Preferred examples of the substituent (Rb₂) include an alkyl group having a carbon number of 1 to 8, a cycloalkyl group having a carbon number of 4 to 7, an alkoxy group having a carbon number of 1 to 8, an alkoxycarbonyl group having a carbon number of 1 to 8, a carboxyl group, a halogen atom, a hydroxyl group, a cyano group and an acid-decomposable group. n₂ represents an integer of 0 to 4. When n₂ is an integer of 2 or more, the plurality of Rb₂'s may be the same or different and also, the plurality of Rb₂'s may combine with each other to form a ring.

Examples of the repeating unit containing a group having a lactone structure represented by any one of formulae (LC1-1) to (LC1-16) include a repeating unit represented by the following formula (AI):

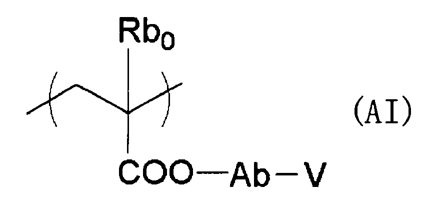

In formula (AI), Rb₀ represents a hydrogen atom, a halogen atom or an alkyl group having a carbon number of 1 to 4.

Preferred examples of the substituent which the alkyl group of Rb₀ may have include a hydroxy group and a halogen atom.

Examples of the halogen atom of Rb₀ include a fluorine atom, a chlorine atom, a bromine atom and an iodine atom.

Rb₀ is preferably a hydrogen atom or a methyl group.

Ab represents an alkylene group, a divalent linking group having a monocyclic or polycyclic alicyclic hydrocarbon structure, a single bond, an ether group, an ester group, a carbonyl group, a carboxyl group, or a divalent group comprising a combination thereof, preferably a single bond or a linking group represented by -Ab₁-CO₂-. Ab₁ is a linear or branched alkylene group or a monocyclic or polycyclic cycloalkylene group, preferably a methylene group, an ethylene group, a cyclohexyl group, an adamantyl group or a norbornyl group.

V represents a group represented by any one of formulae (LC1-1) to (LC1-16).

The repeating unit having a lactone structure usually has an optical isomer, but any optical isomer may be used. One optical isomer may be used alone or a mixture of a plurality of optical isomers may be used. In the case of using primarily one optical isomer, the optical purity (ee) thereof is preferably 90 or more, more preferably 95 or more.

Specific examples of the repeating unit containing a group having a lactone structure are set forth below, but the present invention is not limited thereto.

(In the formulae, Rx is H, CH₃, CH₂OH or CF₃.)

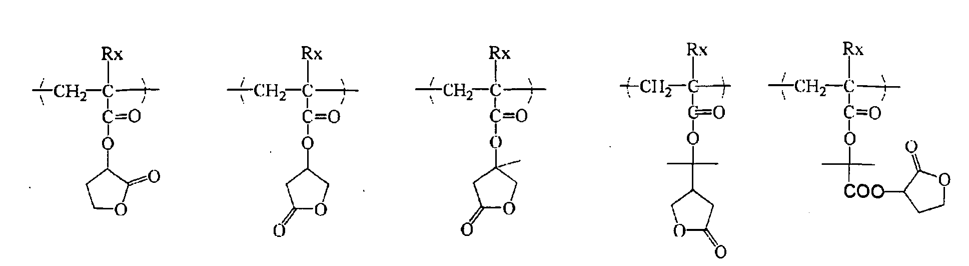

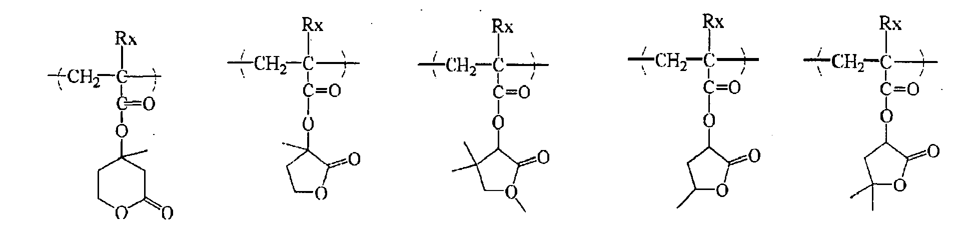

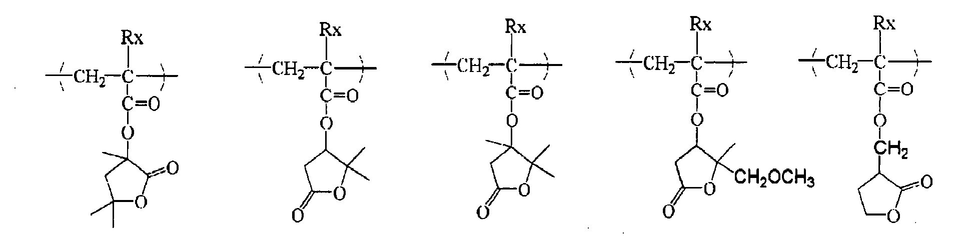

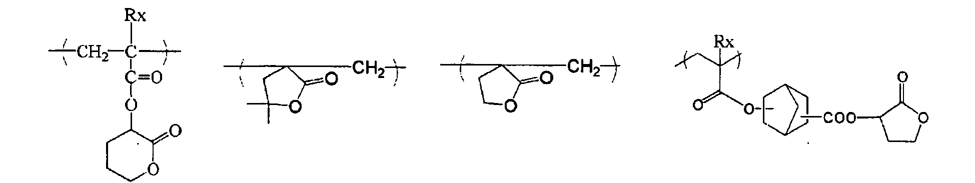

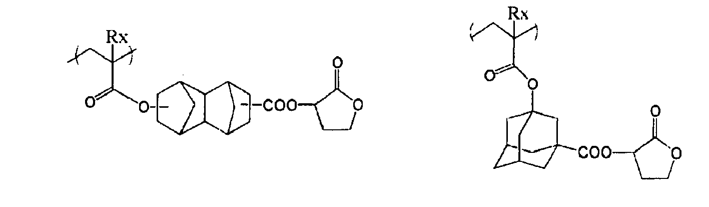

(In the formulae, Rx is H, CH₃, CH₂OH or CF₃.)

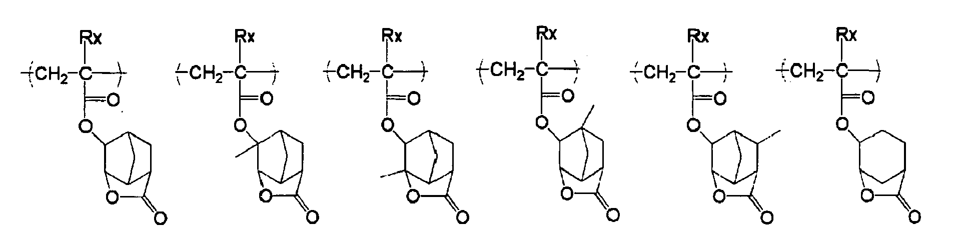

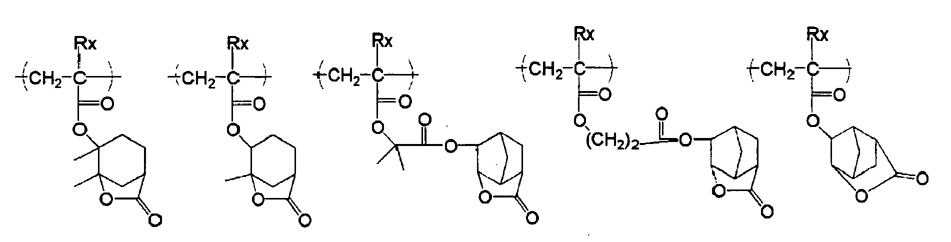

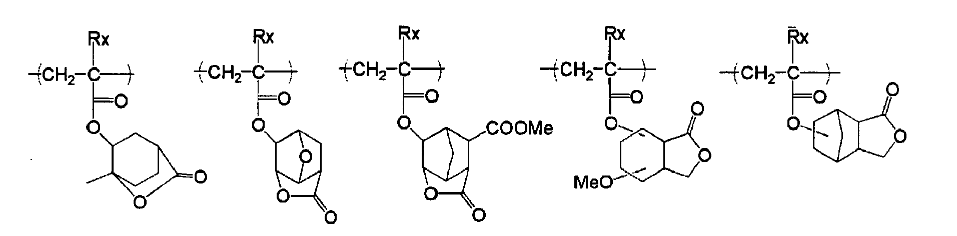

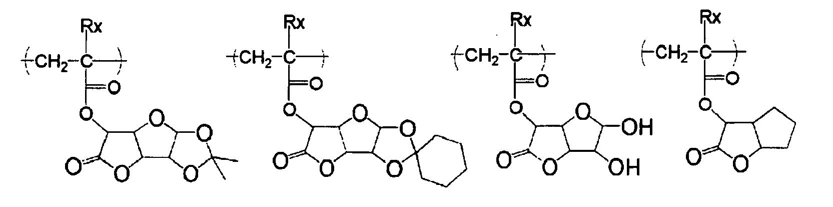

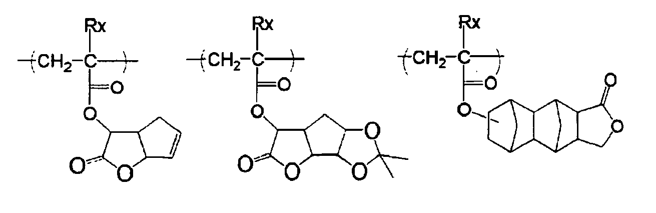

(In the formulae, Rx is H, CH₃, CH₂OH or CF₃.)

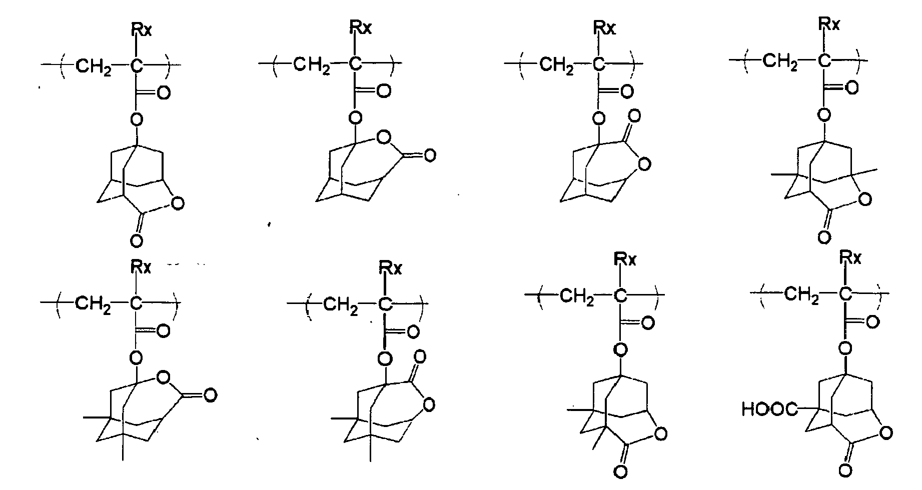

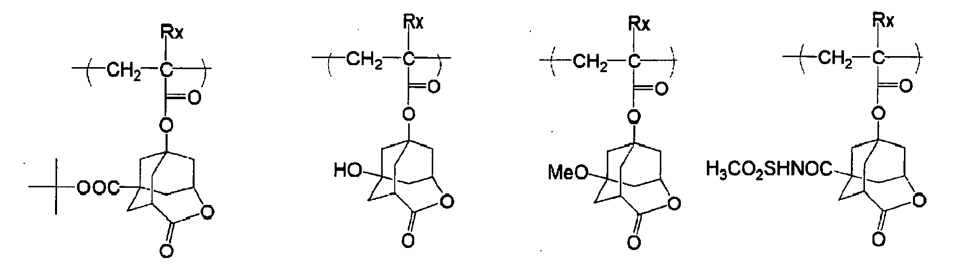

The resin as the component (A) preferably contains a repeating unit having an alicyclic hydrocarbon structure substituted by a polar group. By virtue of this repeating unit, the adhesion to substrate and the affinity for developer are enhanced. The polar group is preferably a hydroxyl group or a cyano group. The repeating unit is preferably a repeating unit having a partial structure represented by the following formula (VIIa) or (VIIb), more preferably a repeating unit represented by the following formula (AIIa) or (AIIb).

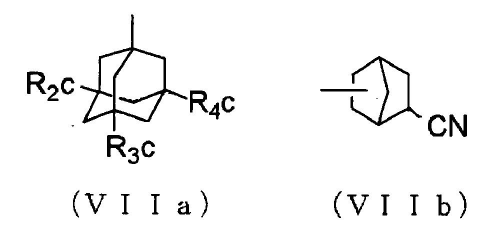

In formula (VIIa), R_{2c} to R_{4c} each independently represents a hydrogen atom, a hydroxyl group or a cyano group, provided that at least one of R_{2c} to R_{4c} represents a hydroxyl group or a cyano group. A partial structure where one or two member out of R_{2c} to R_{4c} is a hydroxyl group with the remaining being a hydrogen atom is preferred, and a partial structure where two members out of R_{2c} to R_{4c} are a hydroxyl group with the remaining being a hydrogen atom is more preferred.

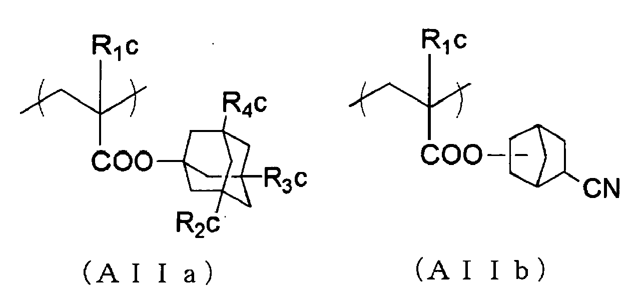

In formulae (AIIa) and (AIIb), R_{1c} represents a hydrogen atom, a methyl group, a trifluoromethyl group or a hydroxymethyl group.

Specific examples of the repeating unit having a structure represented by formula (VIIa) or (VIIb) are set forth below, but the present invention is not limited thereto.

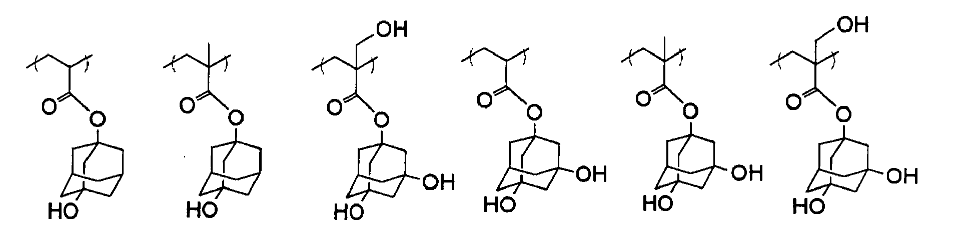

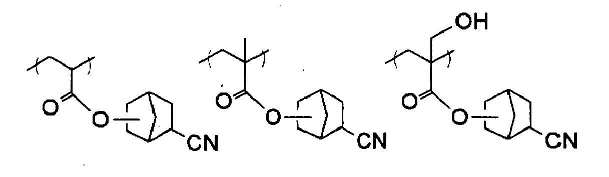

The resin as the component (A) may contain a repeating unit represented by the following formula (VIII):

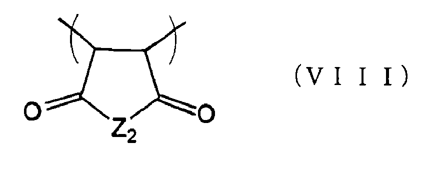

In formula (VIII), Z₂ represents -O- or -N(R₄₁)-. R₄₁ represents a hydrogen atom, a hydroxyl group, an alkyl group or -OSO₂-R₄₂. R₄₂ represents an alkyl group, a cycloalkyl group or a camphor residue. The alkyl group of R₄₁ and R₄₂ may be substituted by a halogen atom (preferably fluorine atom) or the like.

Specific examples of the repeating unit represented by formula (VIII) are set forth below, but the present invention is not limited thereto.

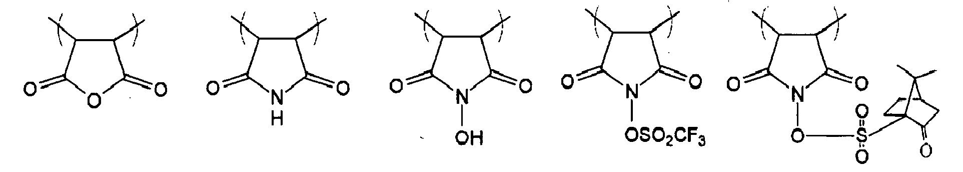

The resin as the component (A) preferably contains a repeating unit having an alkali-soluble group, more preferably a repeating unit having a carboxyl group. By virtue of containing such a repeating unit, the resolution increases in usage of forming contact holes. As for the repeating unit having a carboxyl group, a repeating unit where a carboxyl group is directly bonded to the resin main chain, such as repeating unit by an acrylic acid or a methacrylic acid, a repeating unit where a carboxyl group is bonded to the resin main chain through a linking group, and a repeating unit where an alkali-soluble group is introduced into the polymer chain terminal by using an alkali-soluble group-containing polymerization initiator or chain transfer agent at the polymerization, all are preferred. The linking group may have a monocyclic or polycyclic hydrocarbon structure. An acrylic acid and a methacrylic acid are most preferred.

The resin as the component (A) may contain a repeating unit having from 1 to 3 groups represented by the following formula (F1). By virtue of this repeating unit, the line edge roughness performance is enhanced.

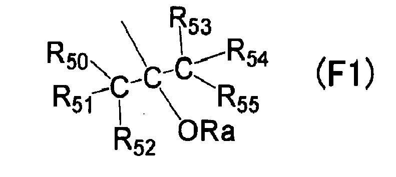

In formula (F1), R₅₀ to R₅₅ each independently represents a hydrogen atom, a fluorine atom or an alkyl group, provided that at least one of R₅₀ to R₅₅ is a fluorine atom or an alkyl group with at least one hydrogen atom being substituted by a fluorine atom.

Ra represents a hydrogen atom or an organic group (preferably an acid-decomposable protective group, an alkyl group, a cycloalkyl group, an acyl group or an alkoxycarbonyl group).

The alkyl group of R₅₀ to R₅₅ may be substituted by a halogen atom (e.g., fluorine), a cyano group or the like and is preferably an alkyl group having a carbon number of 1 to 3, and examples thereof include a methyl group and a trifluoromethyl group.

It is preferred that R₅₀ to R₅₅ all are a fluorine atom.

The organic group represented by Ra is preferably an acid-decomposable protective group or an alkyl, cycloalkyl, acyl, acyl, alkylcarbonyl, alkoxycarbonyl, alkoxycarbonylmethyl, alkoxymethyl or 1-alkoxyethyl group which may have a substituent.

The repeating unit having a group represented by formula (F1) is preferably a repeating unit represented by the following formula (F2):

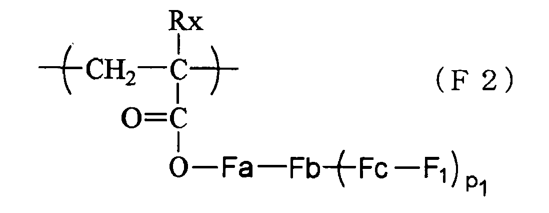

In formula (F2), Rx represents a hydrogen atom, a halogen atom or an alkyl group having a carbon number of 1 to 4. Preferred examples of the substituent which the alkyl group of Rx may have include a hydroxyl group and a halogen atom.

Fa represents a single bond or a linear or branched alkylene group, preferably a single bond.

Fb represents a monocyclic or polycyclic hydrocarbon group.

Fc represents a single bond or a linear or branched alkylene group, preferably a single bond or a methylene group.

F₁ represents a group represented by formula (F1).

p₁ represents 1, 2 or 3.

The cyclic hydrocarbon group in Fb is preferably a cyclopentyl group, a cyclohexyl group or a norbornyl group.

Specific examples of the repeating unit having a structure represented formula (F1) are set forth below.

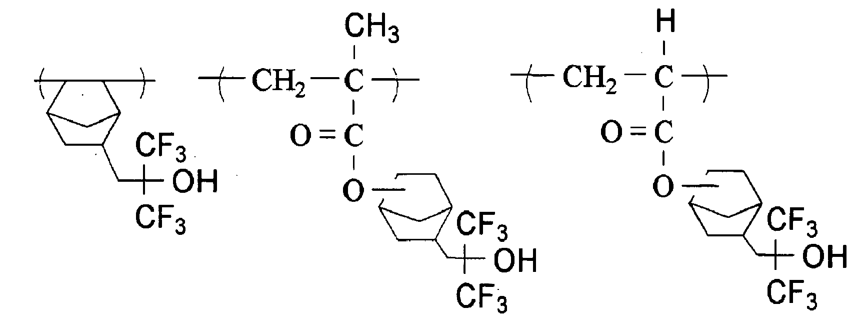

The resin as the component (A) may further contain a repeating unit having an alicyclic hydrocarbon structure and not exhibiting acid decomposability. By virtue of this repeating unit, dissolving out of a low molecular component from the photosensitive film into the immersion liquid at the immersion exposure can be reduced. Examples of such a repeating unit include 1-adamantyl (meth)acrylate, tricyclodecanyl (meth) acrylate and cyclohexyl (meth)-acrylate.

The resin as the component (A) may contain, in addition to the above-described repeating structural units, various repeating structural units for the purpose of controlling the dry etching resistance, suitability for standard developer, adhesion to substrate, resist profile and properties generally required of the resist, such as resolving power, heat resistance and sensitivity.

Examples of such a repeating structural unit include, but are not limited to, repeating structural units corresponding to the monomers described below.

By virtue of such a repeating structural unit, the performance required of the resin as the component (A), particularly,
(1) solubility in the coating solvent,
(2) film-forming property (glass transition point),
(3) alkali developability,
(4) film loss (selection of hydrophilic, hydrophobic or alkali-soluble group),
(5) adhesion of unexposed area to substrate,
(6) dry etching resistance
   and the like, can be subtly controlled.

Examples of the monomer include a compound having one addition-polymerizable unsaturated bond selected from acrylic acid esters, methacrylic acid esters, acrylamides, methacrylamides, allyl compounds, vinyl ethers and vinyl esters.

Other than these, an addition-polymerizable unsaturated compound copolymerizable with the monomer corresponding to the above-described various repeating structural units may be copolymerized.

In the resin as the component (A), the molar ratio of respective repeating structural units contained is appropriately determined to control the dry etching resistance of resist, suitability for standard developer, adhesion to substrate, resist profile and performances generally required of the resist, such as resolving power, heat resistance and sensitivity.

The preferred embodiment of the resin as the component (A) includes a resin where all repeating units have a (meth)acrylate repeating unit, and the resin may be a resin where the repeating units all are a methacrylate repeating unit, a resin where the repeating units all are an acrylate repeating unit, or a resin containing both a methacrylate repeating unit and an acrylate repeating unit. In the case of containing both a methacrylate repeating unit and an acrylate repeating unit, the repeating unit having a polar functional group is preferably an acrylate.

In the resin as the component (A), the content of the repeating unit having an acid-decomposable group is preferably from 10 to 60 mol%, more preferably from 20 to 50 mol%, still more preferably from 25 to 40 mol%, based on all repeating structural units.

In the resin as the component (A), the content of the repeating unit (Aa-1) is preferably from 20 to 50 mol% based on all repeating units.

In the resin as the component (A), the content of the repeating unit (Aa-2) is preferably from 5 to 30 mol% based on all repeating units.

When the positive photosensitive composition of the present invention is used for exposure with ArF, the resin as the component (A) preferably has no aromatic group in view of transparency to ArF light.

A more preferred embodiment is a ternary copolymerization polymer comprising from 20 to 50 mol% of the repeating unit (Aa-1) containing an acid-decomposable group and having a diamantane structure in a group capable of desorbing under the action of an acid, which is present in the acid-decomposable group, or another acid-decomposable group-containing repeating unit, from 20 to 50 mol% of the repeating unit having a lactone structure, and from 5 to 30 mol% of the repeating unit having a diamantane structure substituted by a polar functional group or the repeating unit having another alicyclic hydrocarbon structure substituted by a polar group, or a quaternary copolymerization polymer additionally comprising from 0 to 20 mol% of other repeating units.

Another preferred embodiment is a ternary copolymerization polymer comprising from 5 to 30 mol% of the repeating unit (Aa-2) having a diamantane structure and substantially insusceptible to the action of an acid or an alkali, from 20 to 50 mol% of an acid-decomposable repeating unit having an adamantane structure, and from 20 to 50 mol% of a non-acid-decomposable repeating unit having a lactone group, or a quaternary copolymerization polymer additionally comprising from 0 to 20 mol% of other repeating units. Examples of the acid-decomposable repeating unit include a repeating unit where in the repeating unit represented by formula (PA), Rp₁ has an adamantane structure. Examples of the non-acid-decomposable repeating unit having a lactone group include a repeating unit where in the repeating unit represented by formula (AI), V is a group incapable of desorbing under the action of an acid.

The resin as the component (A) preferably further contains a repeating unit having an adamantane structure. Examples of the repeating unit having an adamantane structure include a repeating unit where in the repeating unit represented by formula (PA), Rp₁ has an adamantane structure, and a repeating unit represented by formula (AIIa).

The resin as the component (A) can be synthesized by an ordinary method (for example, radical polymerization). Examples of the synthesis method in general include a batch polymerization method of dissolving monomer species and an initiator in a solvent and heating the solution, thereby effecting the polymerization, and a dropping polymerization method of adding dropwise a solution containing monomer species and an initiator to a heated solvent over 1 to 10 hours. A dropping polymerization method is preferred. As for the method of adding monomers in the dropping polymerization method, either a method of charging only a solvent into a reaction vessel and adding dropwise a monomer solution thereto, or a method of previously charging a part of monomer species into a reaction vessel and adding dropwise the remaining may be used. The polymerization initiator may be added by the same solution as monomers or may be added from a solution different from the monomer solution. In the case of adding the polymerization initiator from a solution different from the monomer solution, the monomer solution and the initiator solution may be added dropwise at the same or different speed. Examples of the reaction solvent include tetrahydrofuran, 1,4-dioxane, ethers (e.g., diisopropyl ether), ketones (e.g., methyl ethyl ketone, methyl isobutyl ketone), an ester solvent (e.g., ethyl acetate), an amide solvent (e.g., dimethylformamide, dimethylacetamide), and a solvent capable of dissolving the positive photosensitive composition of the present invention, which is described later, such as propylene glycol monomethyl ether acetate, propylene glycol monomethyl ether and cyclohexanone. The polymerization is preferably performed by using the same solvent as the solvent used for the positive photosensitive composition of the present invention. By the use of this solvent, generation of particles during storage can be suppressed.

The polymerization reaction is preferably performed in an inert gas atmosphere such as nitrogen and argon. As for the polymerization initiator, the polymerization is started by using a commercially available radical initiator (e.g., azo-based initiator, peroxide). The radical initiator is preferably an azo-based initiator, and an azo-based initiator having an ester group, a cyano group or a carboxyl group is preferred. Preferred examples of the initiator include azobisisobutyronitrile, azobisdimethylvaleronitrile and dimethyl 2,2'-azobis(2-methyl-propionate). If desired, the initiator is added additionally or in parts. After the completion of reaction, the reactant is charged into a solvent, and the desired polymer is recovered by a method such as powder or solid recovery. The reaction concentration is from 5 to 50 mass%, preferably from 10 to 30 mass%, and the reaction temperature is usually from 10 to 150°C, preferably from 30 to 120°C, more preferably from 60 to 100°C.

The weight average molecular weight of the resin as the component (A) is preferably from 3,000 to 30,000, more preferably from 5,000 to 15,000, further more preferably from 6,000 to 12,000, in terms of polystyrene by the GPC method. By adjusting the molecular weight to a proper range, exposure latitude, development defect, scumming, line edge roughness and the like can be improved.

The weight average molecular weight can be adjusted by appropriately selecting the species of polymerization initiator, the amount of polymerization initiator, the chain transfer agent, the polymerization temperature, the reaction solvent, the concentration of reaction solution, and the polymerization method (e.g., dropping polymerization, batch polymerization), in the polymerization reaction.

The dispersity (Mw/Mn) of the resin as the component (A) is preferably from 1.1 to 3.0, more preferably from 1.2 to 2.5, still more preferably from 1.4 to 2.1. As the molecular weight distribution is smaller, the resolution and resist profile are excellent, the side wall of the resist pattern is smooth, and the roughness property is satisfied.

In order to adjust the dispersity, for example, a resin having a dispersity of 1.0 to 1.5 can be obtained by using a living radical polymerization method. Also, when a resin having a relatively wide dispersity obtained by the polymerization is subjected to reprecipitation or washing with a solvent to thereby remove either one or both of a low molecular weight component and a high molecular weight component by utilizing the difference in the solubility of the resin in a solvent, a resin having a narrow dispersity can be obtained.

The resin as the component (A) preferably has a weight average molecular weight of 3,000 to 30,000 and a dispersity of 1.1 to 3.0.

In the positive photosensitive composition of the present invention, the blending amount of the resin as the component (A) in the entire composition is preferably from 50 to 99.99 mass%, more preferably from 60 to 99.0 mass%, based on the entire solid content.

In the present invention, as for the resin of the component (A), one resin may be used alone or a plurality of resins may be used in combination.

### [2] (A2) Resin not having a group capable of decomposing under the action of an acid

The positive photosensitive composition of the present invention may contain a resin not having a group capable of decomposing under the action of an acid (hereinafter sometimes referred to as a "resin as the component (A2)").

The term "not having a group capable of decomposing under the action of an acid" means that the resin exhibits no or very low decomposability for the action of an acid in the process where the positive photosensitive composition of the present invention is usually used, and contains substantially no group contributing to the image formation utilizing the acid decomposition. Such a resin includes a resin having an alkali-soluble group, and a resin having a group capable of decomposing under the action of an alkali to increase the solubility in an alkali developer.

The resin as the component (A2) is preferably, for example, a resin having at least one repeating unit derived from a (meth)acrylic acid derivative and/or an alicyclic olefin derivative.

Preferred examples of the alkali-soluble group in the resin as the component (A2) include a carboxyl group, a phenolic hydroxyl group, an aliphatic hydroxyl group with the 1- or 2-position being substituted by an electron-withdrawing group, an electron-withdrawing group-substituted amino group (for example, a sulfonamide group, a sulfonimide group and a bis-sulfonylimide group), and an electron-withdrawing group-substituted methylene or methine group (for example, a methylene or methine group substituted by at least two groups selected from a ketone group and an ester group).

The group capable of decomposing under the action of an alkali to increase the solubility in an alkali developer, contained in the resin as the component (A2), is preferably, for example, a lactone group or an acid anhydride group, more preferably a lactone group.

The resin as the component (A2) may further contain a repeating unit having a functional group other than those described above. As for the repeating unit having an another functional group, a repeating unit having an appropriate functional group may be selected in the light of dry etching resistance, hydrophilicity/hydrophobicity, interaction and the like.

Examples of the repeating unit having another functional group include a repeating unit having a polar functional group such as hydroxyl group, cyano group, carbonyl group and ester group, a repeating unit having a monocyclic or polycyclic hydrocarbon structure, a repeating unit having a fluoroalkyl group, and a repeating unit having a plurality of these functional groups.

The weight average molecular weight of the resin as the component (A2) is preferably from 3,000 to 30,000, more preferably from 5,000 to 15,000, still more preferably from 6,000 to 12,000, in terms of polystyrene by the GPC method.

Specific preferred examples of the resin as the component (A2) are set forth below, but the present invention is not limited thereto.

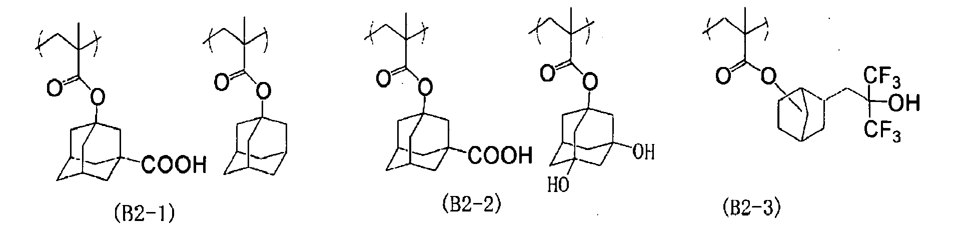

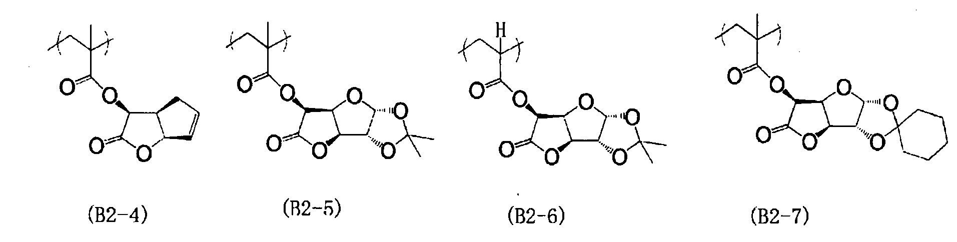

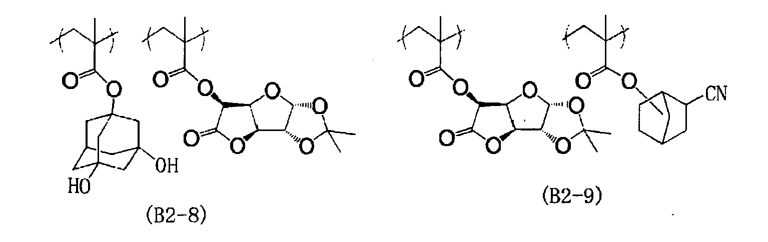

The amount added of the resin as the component (A2) is usually from 0 to 50 mass%, preferably from 0 to 30 mass%, more preferably from 0 to 20 mass%, based on the resin as the component (A).

### [3] (B) Compound capable of generating an acid upon irradiation with actinic rays or radiation

The compound capable of generating an acid upon irradiation with actinic rays or radiation (hereinafter sometimes referred to as an "acid generator"), which is used in the positive photosensitive composition of the present invention, is described below.

The acid generator for use in the present invention may be selected from the compounds generally used as the acid generator.

More specifically, a photoinitiator for photocationic polymerization, a photoinitiator for photoradical polymerization, a photo-decoloring agent for coloring matters, a photo-discoloring agent, a known compound capable of generating an acid upon irradiation with actinic rays or radiation, which is used for microresist and the like, or a mixture thereof may be appropriately selected and used.

Examples thereof include a diazonium salt, a phosphonium salt, a sulfonium salt, an iodonium salt, an imidosulfonate, an oxime sulfonate, a diazodisulfone, a disulfone and an o-nitrobenzyl sulfonate.

Also, a compound where the above-described group or compound capable of generating an acid upon irradiation with actinic rays or radiation is introduced into the polymer main or side chain, such as compounds described in U.S. Patent 3,849,137, German Patent 3,914,407, JP-A-63-26653, JP-A-55-164824, JP-A-62-69263, JP-A-63-146038, JP-A-63-163452, JP-A-62-153853 and JP-A-63-146029, may be used.

Furthermore, a compound capable of generating an acid by the effect of light described, for example, in U.S. Patent 3,779,778 and European Patent 126,712 may also be used.

As for the compound capable of decomposing upon irradiation with actinic rays or radiation to generate an acid, which can be used in combination, the compounds represented by the following formulae (ZI), (ZII) and (ZIII) are preferred.

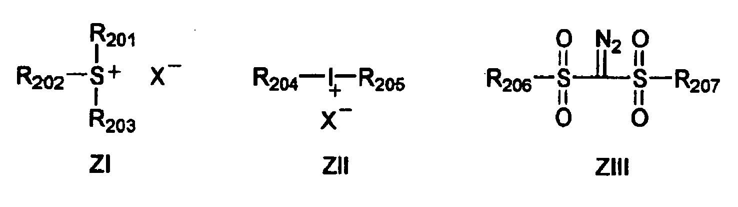

In formula (ZI), R₂₀₁, R₂₀₂ and R₂₀₃ each independently represents an organic group.

X⁻ represents a non-nucleophilic anion.

The carbon number of the organic group as R₂₀₁, R₂₀₂ and R₂₀₃ is preferably from 1 to 30, more preferably from 1 to 20.

Also, two members out of R₂₀₁ to R₂₀₃ may combine to form a ring structure, and the ring may contain an oxygen atom, a sulfur atom, an ester bond, an amide bond or a carbonyl group.

The group formed by combining two members out of R₂₀₁ to R₂₀₃ includes an alkylene group (e.g., butylene, pentylene).

Specific examples of the organic group as R₂₀₁, R₂₀₂ and R₂₀₃ include the corresponding groups in the compounds (ZI-1), (ZI-2) and (ZI-3) which are described later.

The compound may be a compound having a plurality of structures represented by formula (Z1). For example, the compound may be a compound having a structure that at least one of R₂₀₁ to R₂₀₃ in the compound represented by formula (Z1) is bonded to at least one of R₂₀₁ to R₂₀₃ in another compound represented by formula (Z1).

The component (Z1) is more preferably a compound (ZI-1), (ZI-2) or (ZI-3) described below.

The compound (ZI-1) is an arylsulfonium compound where at least one of R₂₀₁ to R₂₀₃ in formula (Z1) is an aryl group, that is, a compound having an arylsulfonium as the cation.

In the arylsulfonium compound, R₂₀₁ to R₂₀₃ all may be an aryl group or a part of R₂₀₁ to R₂₀₃ may be an aryl group with the remaining being an alkyl group or a cycloalkyl group.

Examples of the arylsulfonium compound include a triarylsulfonium compound, a diarylalkylsulfonium compound, an aryldialkylsulfonium compound, a diarylcycloalkyl-sulfonium compound and an aryldicycloalkylsulfonium compound.

The aryl group in the arylsulfonium compound is preferably a phenyl group or a naphthyl group, more preferably a phenyl group. In the case where the arylsulfonium compound has two or more aryl groups, these two or more aryl groups may be the same of different.

The alkyl group which is present, if desired, in the arylsulfonium compound is preferably a linear or branched alkyl group having a carbon number of 1 to 15, and examples thereof include a methyl group, an ethyl group, a propyl group, an n-butyl group, a sec-butyl group and a tert-butyl group.

The cycloalkyl group which is present, if desired, in the arylsulfonium compound is preferably a cycloalkyl group having a carbon number of 3 to 15, and examples thereof include a cyclopropyl group, a cyclobutyl group and a cyclohexyl group.

The aryl group, alkyl group and cycloalkyl group of R₂₀₁ to R₂₀₃ each may have, as the substituent, an alkyl group (for example, an alkyl group having a carbon number of 1 to 15), a cycloalkyl group (for example, a cycloalkyl group having a carbon number of 3 to 15), an aryl group (for example, an aryl group having a carbon number of 6 to 14), an alkoxy group (for example, an alkoxy group having a carbon number of 1 to 15), a halogen atom, a hydroxyl group or a phenylthio group. The substituent is preferably a linear or branched alkyl group having a carbon number of 1 to 12, a cycloalkyl group having a carbon number of 3 to 12, or a linear, branched or cyclic alkoxy group having a carbon number of 1 to 12, and most preferably an alkyl group having a carbon number of 1 to 4, or an alkoxy group having a carbon number of 1 to 4. The substituent may be substituted to any one of three members R₂₀₁ to R₂₀₃ or may be substituted to all of these three members. In the case where R₂₀₁ to R₂₀₃ are an aryl group, the substituent is preferably substituted at the p-position of the aryl group.

Examples of the non-nucleophilic anion of X⁻ in formula (ZI) include a sulfonate anion, a carboxylate anion, a sulfonylimide anion, a bis(alkylsulfonyl)imide anion and a tris(alkylsulfonyl)methyl anion.

The non-nucleophilic anion is an anion having an extremely low ability of causing a nucleophilic reaction, and this anion can suppress the decomposition in aging due to an intramolecular nucleophilic reaction. By virtue of this anion, the aging stability of the photosensitive composition is enhanced.

Examples of the sulfonate anion include an aliphatic sulfonate anion, an aromatic sulfonate anion and a camphorsulfonate anion.

Examples of the carboxylate anion include an aliphatic carboxylate anion, an aromatic carboxylate anion and an aralkylcarboxylate anion.

The aliphatic hydrocarbon group in the aliphatic sulfonate anion includes an alkyl group preferably having a carbon number of 1 to 30, such as methyl group, ethyl group, propyl group, isopropyl group, n-butyl group, isobutyl group, sec-butyl group, pentyl group, neopentyl group, hexyl group, heptyl group, octyl group, nonyl group, decyl group, undecyl group, dodecyl group, tridecyl group, tetradecyl group, pentadecyl group, hexadecyl group, heptadecyl group, octadecyl group, nonadecyl group and eicosyl group; and a cycloalkyl group preferably having a carbon number of 3 to 30, such as cyclopropyl group, cyclopentyl group, cyclohexyl group, adamantyl group, norbornyl group and boronyl group.

The aromatic group in the aromatic sulfonate anion includes an aryl group preferably having a carbon number of 6 to 14, such as phenyl group, tolyl group and naphthyl group.

The alkyl group, cycloalkyl group and aryl group in the aliphatic sulfonate anion and aromatic sulfonate anion each may have a substituent.

Examples of the substituent include a halogen atom, an alkyl group, an alkoxy group and an alkylthio group.

Examples of the halogen atom include a chlorine atom, a bromine atom, a fluorine atom and an iodine atom.

Examples of the alkyl group include an alkyl group preferably having a carbon number of 1 to 15, such as methyl group, ethyl group, propyl group, isopropyl group, n-butyl group, isobutyl group, sec-butyl group, pentyl group, neopentyl group, hexyl group, heptyl group, octyl group, nonyl group, decyl group, undecyl group, dodecyl group, tridecyl group, tetradecyl group, pentadecyl group, hexadecyl group, heptadecyl group, octadecyl group, nonadecyl group and eicosyl group.

Examples of the alkoxy group include an alkoxy group preferably having a carbon number of 1 to 5, such as methoxy group, ethoxy group, propoxy group and butoxy group.

Examples of the alkylthio group include an alkylthio group preferably having a carbon number of 1 to 15, such as methylthio group, ethylthio group, propylthio group, isopropylthio group, n-butylthio group, isobutylthio group, sec-butylthio group, pentylthio group, neopentylthio group, hexylthio group, heptylthio group, octylthio group, nonylthio group, decylthio group, undecylthio group, dodecylthio group, tridecylthio group, tetradecylthio group, pentadecylthio group, hexadecylthio group, heptadecylthio group, octadecylthio group, nonadecylthio group and eicosylthio group. The alkyl group, alkoxy group and alkylthio group each may be further substituted by a halogen atom (preferably a fluorine atom).

Examples of the aliphatic hydrocarbon group in the aliphatic carboxylate anion are the same as those of the aliphatic hydrocarbon group in the aliphatic sulfonate anion.

Examples of the aromatic group in the aromatic carboxylate anion are the same as those of the aromatic group in the aromatic sulfonate anion.

Examples of the aralkyl group in the aralkylcarboxylate anion include an aralkyl group preferably having a carbon number of 6 to 12, such as benzyl group, phenethyl group, naphthylmethyl group, naphthylethyl group and naphthylmethyl group.

The alkyl group, cycloalkyl group, aryl group and aralkyl group in the aliphatic carboxylate anion, aromatic carboxylate anion and aralkylcarboxylate anion each may have a substituent, and examples of the substituent include the same halogen atom, alkyl group, alkoxy group and alkylthio group as those in the aliphatic sulfonate anion and aromatic sulfonate anion.

Examples of the sulfonylimide anion include a saccharine anion.

The alkyl group in the bis(alkylsulfonyl)imide anion and tris(alkylsulfonyl)methyl anion is preferably an alkyl group having a carbon number of 1 to 5, and examples thereof include a methyl group, an ethyl group, a propyl group, an isopropyl group, an n-butyl group, an isobutyl group, a sec-butyl group, a pentyl group and a neopentyl group. This alkyl group may have a substituent, and examples of the substituent include a halogen atom, a halogen atom-substituted alkyl group, an alkoxy group and an alkylthio group, with a fluorine atom-substituted alkyl group being preferred.

Other examples of the non-nucleophilic anion include a phosphorus fluoride anion, a boron fluoride anion and an antimony fluoride anion.

The non-nucleophilic anion of X⁻ is preferably an aliphatic sulfonate anion substituted by fluorine atom, an aromatic sulfonate anion substituted by fluorine atom or a fluorine atom-containing group, a bis(alkylsulfonyl)imide anion with the alkyl group being substituted by fluorine atom, or a tris(alkylsulfonyl)methide anion with the alkyl group being substituted by fluorine atom. The non-nucleophilic anion of X⁻ is more preferably a fluorine-substituted aliphatic sulfonate anion having a carbon number of 4 to 8, still more preferably nonafluoro-butanesulfonate anion or perfluorooctanesulfonate anion.

The compound (ZI-2) is described below.

The compound (ZI-2) is a compound where R₂₀₁ to R₂₀₃ in formula (ZI) each independently represents an aromatic ring-free organic group. The aromatic ring as used herein includes an aromatic ring containing a heteroatom.

The aromatic ring-free organic group as R₂₀₁ to R₂₀₃ preferably has a carbon number of 1 to 30, more preferably from 1 to 20.

R₂₀₁ to R₂₀₃ each is independently, preferably an alkyl group, a cycloalkyl group, an allyl group or a vinyl group, more preferably a linear, branched or cyclic 2-oxoalkyl group or an alkoxycarbonylmethyl group, and most preferably a linear or branched 2-oxoalkyl group.

The alkyl group as R₂₀₁ to R₂₀₃ may be either linear or branched and is preferably a linear or branched alkyl group having a carbon number of 1 to 10 (e.g., methyl, ethyl, propyl, butyl, pentyl). The alkyl group is more preferably a linear or branched 2-oxoalkyl group or an alkoxycarbonylmethyl group.

The cycloalkyl group as R₂₀₁ to R₂₀₃ is preferably a cycloalkyl group having a carbon number of 3 to 10 (e.g., cyclopentyl, cyclohexyl, norbornyl). The cycloalkyl group is more preferably a cyclic 2-oxoalkyl group.

The linear, branched or cyclic 2-oxoalkyl group as R₂₀₁ to R₂₀₃ is preferably a group having >C=O at the 2-position of the above-described alkyl or cycloalkyl group.

The alkoxy group in the alkoxycarbonylmethyl group as R₂₀₁ to R₂₀₃ is preferably an alkoxy group having a carbon number of 1 to 5 (e.g., methoxy, ethoxy, propoxy, butoxy, pentoxy).

R₂₀₁ to R₂₀₃ each may be further substituted by a halogen atom, an alkoxy group (for example, an alkoxy group having a carbon number of 1 to 5), a hydroxyl group, a cyano group or a nitro group.

The compound (ZI-3) is a compound represented by the following formula (ZI-3), and this is a compound having a phenacylsulfonium salt structure.

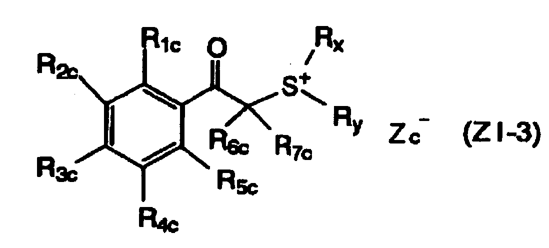

In formula (ZI-3), R_{1c} to R_{5c} each independently represents a hydrogen atom, an alkyl group, a cycloalkyl group, an alkoxy group or a halogen atom.

R_{6c} and R_{7c} each independently represents a hydrogen atom, an alkyl group or a cycloalkyl group.

Rₓ and Ry each independently represents an alkyl group, a cycloalkyl group, an allyl group or a vinyl group.

Any two or more members out of R_{1c} to R_{5c}, a pair of R_{6c} and R_{7c} or a pair of Rₓ and R_{y} may combine with each other to form a ring structure, and the ring structure may contain an oxygen atom, a sulfur atom, an ester bond or an amide bond. Examples of the group formed by combining any two or more members out of R_{1c} to R_{5c} or combining a pair of R_{6c} and R_{7c} or of Rₓ and R_{y} include a butylene group and a pentylene group.

Zc⁻ represents a non-nucleophilic anion, and examples thereof are the same as those of the non-nucleophilic anion of X⁻ in formula (I).

The alkyl group as R_{1c} to R_{7c}, which may be linear or branched, is, for example, a linear or branched alkyl group having a carbon number of 1 to 20, preferably a linear or branched alkyl group having a carbon number of 1 to 12 (for example, a methyl group, an ethyl group, a linear or branched propyl group, a linear or branched butyl group, or a linear or branched pentyl group).

The cycloalkyl group as R_{1c} to R_{7c} is preferably a cycloalkyl group having a carbon number of 3 to 8 (e.g., cyclopentyl, cyclohexyl).

The alkoxy group as R_{1c} to R_{5c}, which may be linear, branched or cyclic, is, for example, an alkoxy group having a carbon number of 1 to 10, preferably a linear or branched alkoxy group having a carbon number of 1 to 5 (for example, a methoxy group, an ethoxy group, a linear or branched propoxy group, a linear or branched butoxy group, or a linear or branched pentoxy group) or a cyclic alkoxy group having a carbon number of 3 to 8 (e.g., cyclopentyloxy, cyclohexyloxy).

A compound where any one of R_{1c} to R_{5c} is a linear or branched alkyl group, a cycloalkyl group or a linear, branched or cyclic alkoxy group is preferred, and a compound where the sum of carbon numbers of R_{1c} to R_{5c} is from 2 to 15 is more preferred. In this case, the solubility in a solvent is more enhanced and the generation of particles during storage is suppressed.

Examples of the alkyl group as Rₓ and Ry are the same as those of the alkyl group as R_{1c} to R_{7c}. The alkyl group as Rₓ and Ry is preferably a linear or branched 2-oxoalkyl group or an alkoxycarbonylmethyl group are preferred. Examples of the linear or branched 2-oxoalkyl group include a group having >C=O at the 2-position of the alkyl group as R_{1c} to R_{7c}. Examples of the alkoxy group in the alkoxycarbonylmethyl group are the same as those of the alkoxy group as R_{1c} to R_{5c}.

Examples of the cycloalkyl group as Rₓ and Ry are the same as those of the cycloalkyl group as R_{1c} to R_{7c}. The cycloalkyl group as Rₓ and Ry is preferably a cyclic 2-oxoalkyl group. Examples of the cyclic 2-oxoalkyl group include a group having >C=O at the 2-position of the cycloalkyl group as R_{1c} to R_{7c}.

Rₓ and Ry each is preferably an alkyl or cycloalkyl group having a carbon number of 4 or more, more preferably 6 or more, still more preferably 8 or more.

In formulae (ZII) and (ZIII), R₂₀₄ to R₂₀₇ each independently represents an aryl group, an alkyl group or a cycloalkyl group.

The aryl group as R₂₀₄ to R₂₀₇ is preferably a phenyl group or a naphthyl group, more preferably a phenyl group.

The alkyl group as R₂₀₄ to R₂₀₇, which may be linear or branched, is preferably a linear or branched alkyl group having a carbon number of 1 to 10 (e.g., methyl, ethyl, propyl, butyl, pentyl).

The cycloalkyl group as R₂₀₄ to R₂₀₇ is preferably a cycloalkyl group having a carbon number of 3 to 10 (e.g., cyclopentyl, cyclohexyl, norbornyl).

The aryl group, alkyl group and cycloalkyl group of R₂₀₄ to R₂₀₇ each may have a substituent. Examples of the substituent which the aryl group, alkyl group and cycloalkyl group of R₂₀₄ to R₂₀₇ each may have include an alkyl group (for example, an alkyl group having a carbon number of 1 to 15), a cycloalkyl group (for example, a cycloalkyl group having a carbon number of 3 to 15), an aryl group (for example, an aryl group having a carbon number of 6 to 15), an alkoxy group (for example, an alkoxy group having a carbon number of 1 to 15), a halogen atom, a hydroxyl group and a phenylthio group.

X⁻ represents a non-nucleophilic anion, and examples thereof are the same as those of the non-nucleophilic anion of X⁻ in formula (ZI).

Other examples of the compound capable of decomposing upon irradiation with actinic rays or radiation to generate an acid, which can be used, include the compounds represented by the following formulae (ZIV), (ZV) and (ZVI).

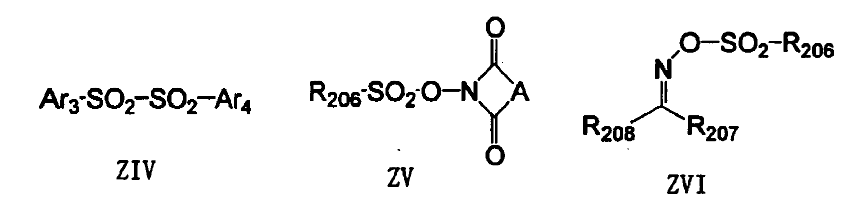

In formulae (ZIV) to (ZVI), Ar₃ and Ar₄ each independently represents an aryl group.

R₂₀₆, R₂₀₇ and R₂₀₈ each independently represents an alkyl group, a cycloalkyl group or an aryl group.

A represents an alkylene group, an alkenylene group or an arylene group.

Among the compounds capable of decomposing upon irradiation with actinic rays or radiation to generate an acid, which may be used, the compounds represented by formulae (ZI) to (ZIII) are preferred.

Out of the compounds capable of decomposing upon irradiation with actinic rays or radiation to generate an acid, which may be used, more preferred compounds are set forth below.

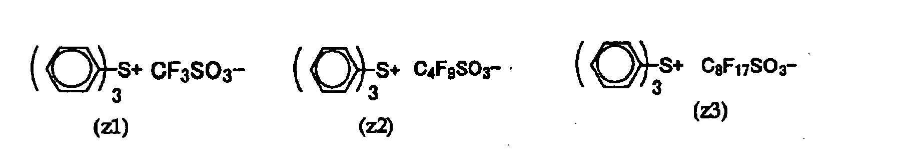

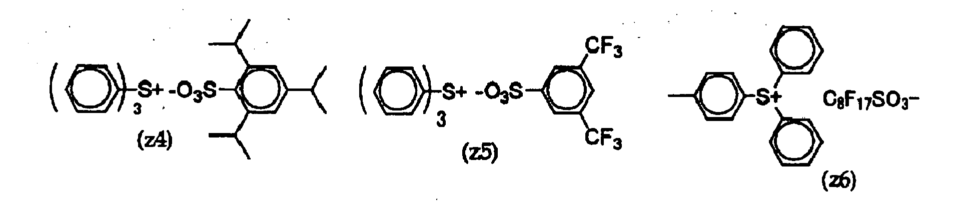

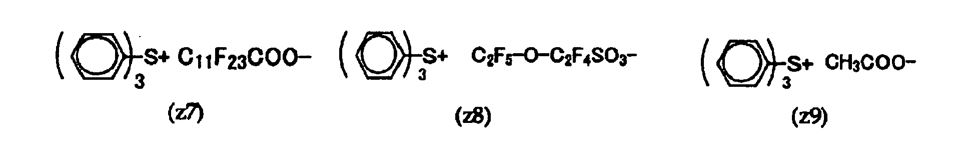

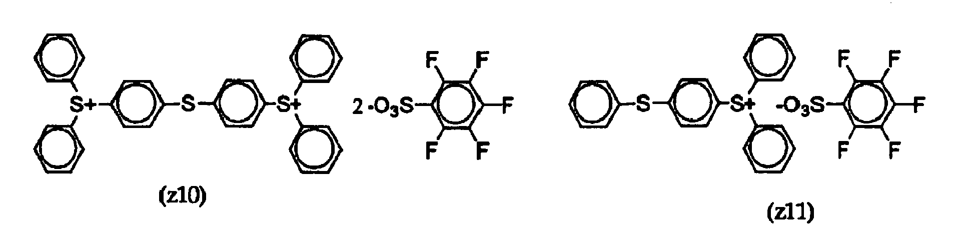

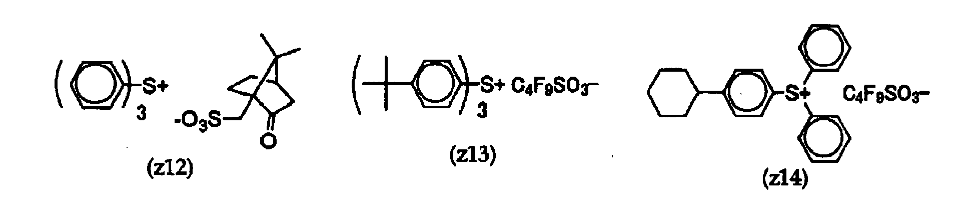

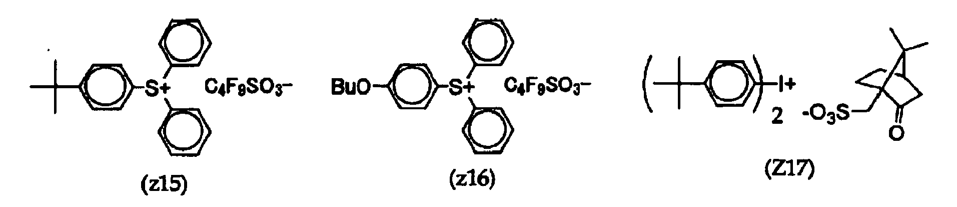

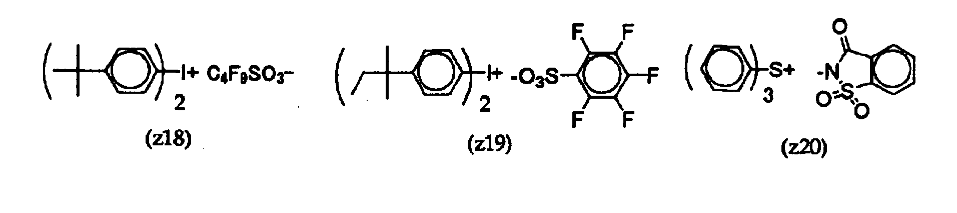

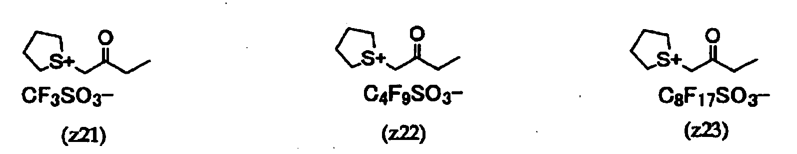

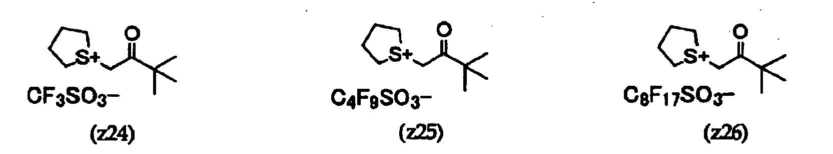

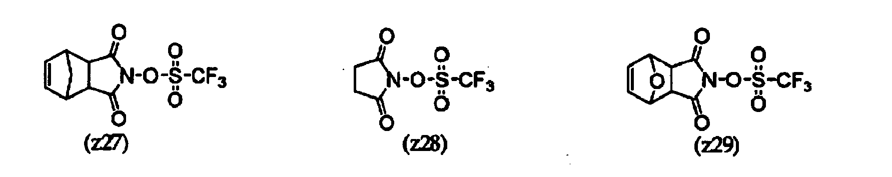

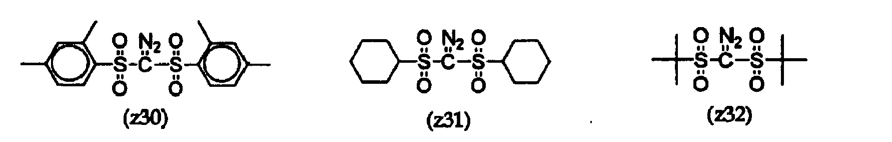

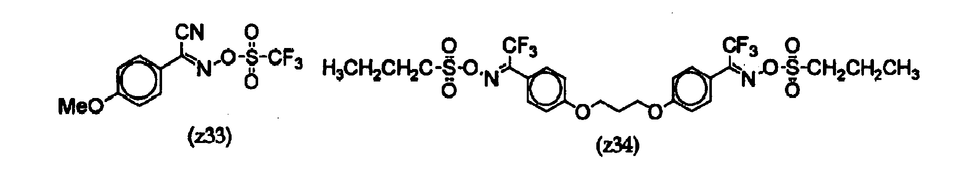

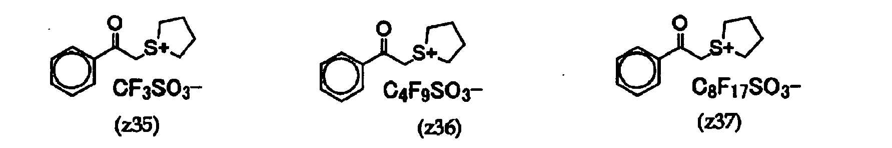

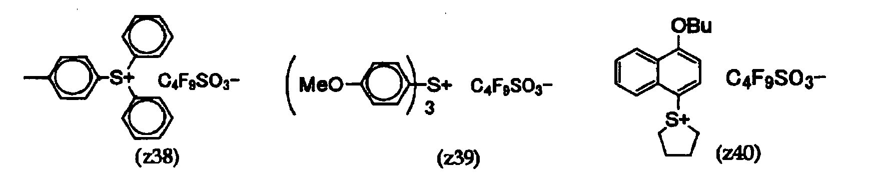

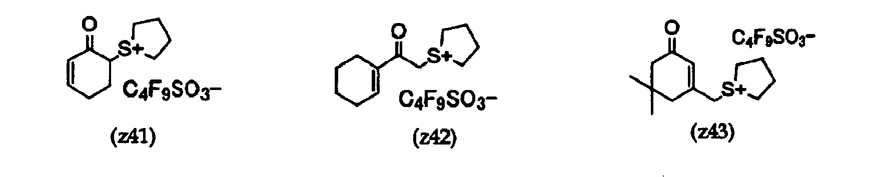

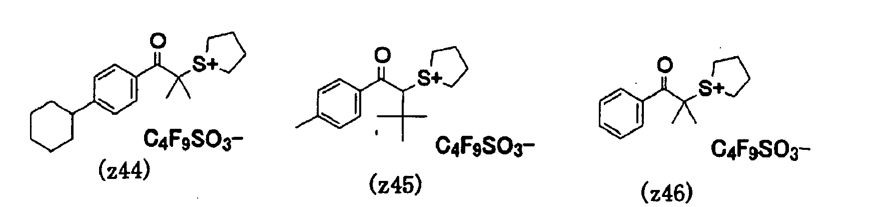

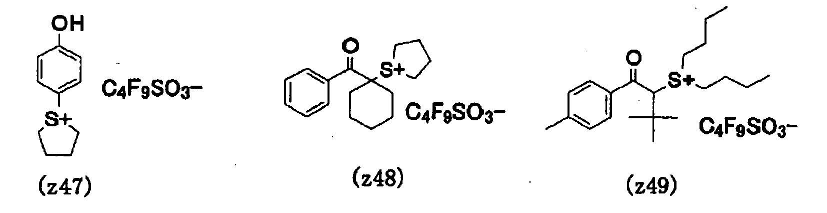

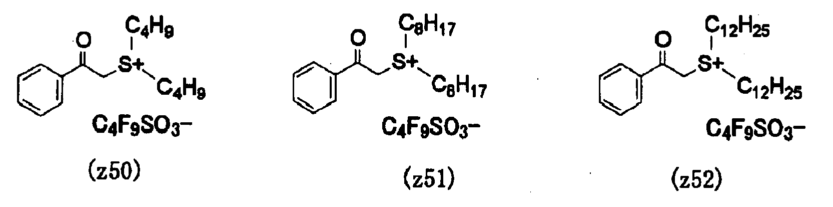

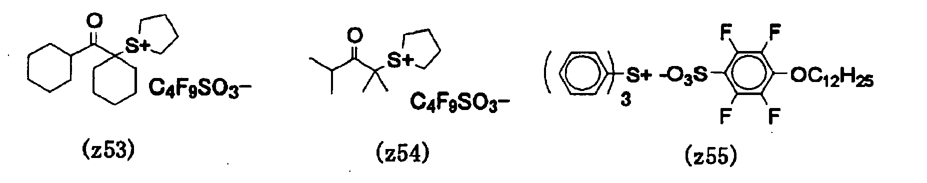

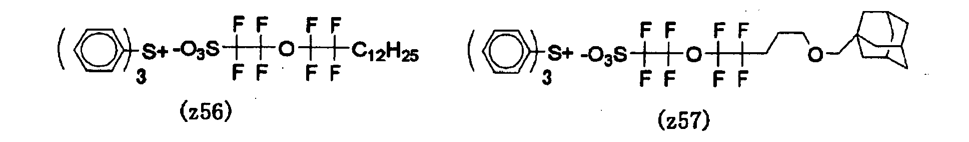

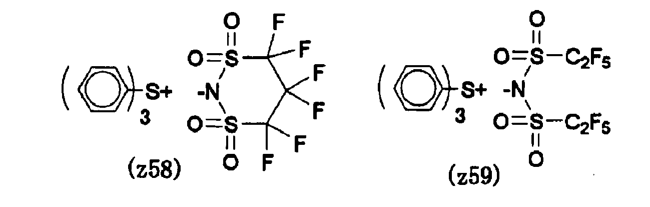

One of the compounds as the component (B) may be used alone or two or more thereof may be used in combination.

The content of the compound as the component (B) in the positive photosensitive composition is preferably from 0.1 to 20 mass%, more preferably from 0.5 to 10 mass%, still more preferably from 1 to 7 mass%, based on the solid content of the composition.

### [4] (C) Compound represented by formula (1)

The surfactant for use in the positive photosensitive composition of the present invention is a compound represented by the following formula (1) (hereinafter, sometimes referred to as a "surfactant (C)").

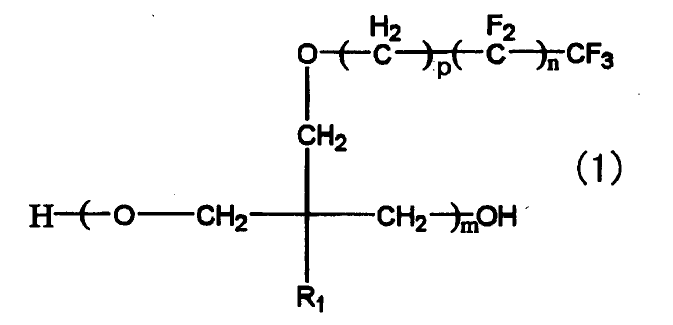

In formula (1), R₁ represents a hydrogen atom or an alkyl group,
m represents an integer of 1 to 30,
n represents an integer of 0 to 3, and
p represents an integer of 0 to 5.

The alkyl group of R₁ is preferably a linear or branched alkyl group having a carbon number of 1 to 5, and examples thereof include a methyl group, an ethyl group, a propyl group, an n-butyl group, a sec-butyl group and a tert-butyl group. Among these, a methyl group, an ethyl group and a propyl group are more preferred.

In formula (1), it is preferred that m is an integer of 1 to 25, n is an integer of 0 to 2, and p is an integer of 0 to 3.

Examples of the commercial product for the surfactant represented by formula (1) include PF636 (n=0, m=6, p=1, R₁ = methyl group), PF6320 (n=0, m=20, p=1, R₁ = methyl group), PF656 (n=1, m=6, p=1, R₁ = methyl group), and PF6520 (n=1, m=20, p=1, R₁ = methyl group) (all are produced by OMNOVA).

The positive photosensitive composition of the present invention contains the surfactant (C) together with the above-described resin, whereby the Dark-Bright difference is reduced.

Also, the positive photosensitive composition of the present invention ensures that the sensitivity, resolution and adhesion are good and a resist pattern with less development defects can be formed. Furthermore, when applied to immersion exposure, the defocus latitude is broad and a good profile can be obtained.

The amount used of the surfactant (C) is preferably from 0.00001 to 0.5 mass%, more preferably from 0.0001 to 0.1 mass%, based on the entire amount of the positive photosensitive composition (excluding the solvent).

In the present invention, another surfactant may be used in combination with the surfactant (C).

The ratio of the surfactant (C) and another surfactant used is preferably, in terms of the mass ratio (surfactant (C)/another surfactant), from 60/40 to 99/1, more preferably from 70/30 to 99/1.

Examples of the another surfactant which can be used in combination include surfactants described in JP-A-62-36663, JP-A-61-226746, JP-A-61-226745, JP-A-62-170950, JP-A-63-34540, JP-A-7-230165, JP-A-8-62834, JP-A-9-54432, JP-A-9-5988, JP-A-2002-277862 and U.S. Patents 5,405,720, 5,360,692, 5,529,881, 5,296,330, 5,436,098, 5,576,143, 5,294,511 and 5,824,451. Examples of the commercially available surfactant therefor include a fluorine-containing surfactant and a silicon-containing surfactant, such as EFtop EF301 and EF303 (produced by Shin-Akita Kasei K.K.), Florad FC430 and 431 (produced by Sumitomo 3M Inc.), Megafac F171, F173, F176, F189 and R08 (produced by Dainippon Ink & Chemicals, Inc.), Surflon S-382, SC101, 102, 103, 104, 105 and 106 (produced by Asahi Glass Co., Ltd.), and Troysol S-366 (produced by Troy Chemical). Also, polysiloxane polymer KP-341 (produced by Shin-Etsu Chemical Co., Ltd.) may be used.

Other than these known surfactants, examples of the surfactant include a surfactant using a polymer having a fluoro-aliphatic group derived from a fluoro-aliphatic compound produced by the telomerization process (also called telomer process) or oligomerization process (also called oligomer process). The fluoro-aliphatic compound can be synthesized by the method described in JP-A-2002-90991.

The polymer having a fluoro-aliphatic group is preferably a copolymer of a fluoro-aliphatic group-containing monomer with (poly(oxyalkylene)) acrylate and/or (poly(oxyalkylene)) methacrylate, and the polymer may have an irregular distribution or may be a block copolymer. Examples of the poly(oxyalkylene) group include a poly(oxyethylene) group, a poly(oxypropylene) group and a poly(oxybutylene) group. A unit having alkylenes differing in the chain length within the same chain, such as block-linked poly(oxyethylene, oxypropylene and oxyethylene) and block-linked poly(oxyethylene and oxypropylene), may also be used. Furthermore, the copolymer of a fluoro-aliphatic group-containing monomer and a (poly(oxyalkylene)) acrylate (or methacrylate) may be not only a binary copolymer but also a ternary or greater copolymer obtained by simultaneously copolymerizing two or more different fluoro-aliphatic group-containing monomers or two or more different (poly(oxyalkylene)) acrylates (or methacrylates).

Examples thereof include commercially available surfactants such as Megafac F178, F-470, F-473, F-475, F-476 and F-472 (produced by Dainippon Ink & Chemicals, Inc.), and further include a copolymer of a C₆F₁₃ group-containing acrylate (or methacrylate) with a (poly(oxyalkylene)) acrylate (or methacrylate), a copolymer of a C₆F₁₃ group-containing acrylate (or methacrylate) with a (poly(oxyethylene)) acrylate (or methacrylate) and a (poly(oxypropylene)) acrylate (or methacrylate), a copolymer of a C₈F₁₇ group-containing acrylate (or methacrylate) with a (poly(oxyalkylene)) acrylate (or methacrylate), and a copolymer of a C₈F₁₇ group-containing acrylate (or methacrylate) with a (poly(oxyethylene)) acrylate (or methacrylate) and a (poly(oxypropylene)) acrylate (or methacrylate).

Furthermore, a surfactant other than the fluorine-containing and/or silicon-containing surfactant may also be used in combination. Specific examples thereof include a nonionic surfactant such as polyoxyethylene alkyl ethers (e.g., polyoxyethylene lauryl ether, polyoxyethylene stearyl ether, polyoxyethylene cetyl ether, polyoxyethylene oleyl ether), polyoxyethylene alkylallyl ethers (e.g., polyoxyethylene octylphenol ether, polyoxyethylene nonylphenol ether), polyoxyethylene-polyoxypropylene block copolymers, sorbitan fatty acid esters (e.g., sorbitan monolaurate, sorbitan monopalmitate, sorbitan monostearate, sorbitan monooleate, sorbitan trioleate, sorbitan tristearate), and polyoxyethylene sorbitan fatty acid esters (e.g., polyoxyethylene sorbitan monolaurate, polyoxyethylene sorbitan monopalmitate, polyoxyethylene sorbitan monostearate, polyoxyethylene sorbitan trioleate, polyoxyethylene sorbitan tristearate).

### [5] (D) Solvent

The positive photosensitive composition of the present invention is used by dissolving respective components in a predetermined organic solvent.

Examples of the solvent which can be used include an organic solvent such as ethylene dichloride, cyclohexanone, cyclopentanone, 2-heptanone, γ-butyrolactone, methyl ethyl ketone, ethylene glycol monomethyl ether, ethylene glycol monoethyl ether, 2-methoxyethyl acetate, ethylene glycol monoethyl ether acetate, propylene glycol monomethyl ether, propylene glycol monomethyl ether acetate, toluene, ethyl acetate, methyl lactate, ethyl lactate, methyl methoxypropionate, ethyl ethoxypropionate, methyl pyruvate, ethyl pyruvate, propyl pyruvate, N,N-dimethylformamide, dimethylsulfoxide, N-methylpyrrolidone and tetrahydrofuran.

In the present invention, one organic solvent may be used alone or some organic solvents may be used as a mixture, but it is preferred to use a mixed solvent containing two or more solvents having different functional groups. By this use, the solubility of the material is enhanced and not only production of particles in aging can be suppressed but also a good pattern profile can be obtained. Preferred examples of the functional group contained in the solvent include an ester group, a lactone group, a hydroxyl group, a ketone group and a carbonate group. The mixed solvent having different functional groups is preferably a mixed solvent in any one of the following (S1) to (S5):
(S1) a mixed solvent prepared by mixing a hydroxyl group-containing solvent and a hydroxyl group-free solvent;
(S2) a mixed solvent prepared by mixing a solvent having an ester group and a solvent having a ketone structure;
(S3) a mixed solvent prepared by mixing a solvent having an ester structure and a solvent having a lactone structure;
(S4) a mixed solvent prepared by mixing a solvent having an ester structure, a solvent having a lactone structure, and a hydroxyl group-containing solvent; and
(S5) a mixed solvent prepared by mixing a solvent having an ester structure, a solvent having a carbonate structure, and a hydroxyl group-containing solvent.

By the use of such a mixed solvent, production of particles during storage of the resist solution can be reduced and generation of a defect at the coating can be suppressed.

Examples of the hydroxyl group-containing solvent include ethylene glycol, ethylene glycol monomethyl ether, ethylene glycol monoethyl ether, propylene glycol, propylene glycol monomethyl ether, propylene glycol monoethyl ether and ethyl lactate. Among these, propylene glycol monomethyl ether and ethyl lactate are preferred.

Examples of the hydroxy group-free solvent include propylene glycol monomethyl ether acetate, ethyl ethoxypropionate, 2-heptanone, γ-butyrolactone, cyclohexanone, butyl acetate, N-methylpyrrolidone, N,N-dimethylacetamide and dimethyl sulfoxide. Among these, propylene glycol monomethyl ether acetate, ethyl ethoxypropionate, 2-heptanone, γ-butyrolactone, cyclohexanone and butyl acetate are preferred, and propylene glycol monomethyl ether acetate, ethyl ethoxypropionate, 2-heptanone and cyclohexanone are more preferred.

Examples of the solvent having a ketone structure include cyclohexanone and 2-heptanone, with cyclohexanone being preferred.

Examples of the solvent having an ester structure include propylene glycol monomethyl ether acetate, ethyl ethoxypropionate and butyl acetate, with propylene glycol monomethyl ether acetate being preferred.

Examples of the solvent having a lactone structure include γ-butyrolactone.

Examples of the solvent having a carbonate structure include propylene carbonate and ethylene carbonate, with propylene carbonate being preferred.

The mixing ratio (by mass) between the hydroxy group-containing solvent and the hydroxy group-free solvent is from 1/99 to 99/1, preferably from 10/90 to 90/10, more preferably from 20/80 to 60/40. A mixed solvent containing the hydroxy group-free solvent in a proportion of 50 mass% or more is particularly preferred in view of coating uniformity.

The mixing ratio (by mass) between the solvent having an ester structure and the solvent having a ketone structure is from 1/99 to 99/1, preferably from 10/90 to 90/10, more preferably from 40/60 to 80/20. A mixed solvent containing the solvent having an ester structure in a proportion of 50 mass% or more is particularly preferred in view of coating uniformity.

The mixing ratio (by mass) between the solvent having an ester structure and the solvent having a lactone structure is from 70/30 to 99/1, preferably from 80/20 to 99/1, more preferably from 90/10 to 99/1. A mixed solvent containing the solvent having an ester structure in a proportion of 70 mass% or more is particularly preferred in view of aging stability.

In the case of mixing a solvent having an ester structure, a solvent having a lactone structure and a hydroxyl group-containing solvent, the mixed solvent preferably contains from 30 to 80 mass% of the solvent having an ester structure, from 1 to 20 mass% of the solvent having a lactone structure, and from 10 to 60 mass% of the hydroxyl group-containing solvent.

In the case of mixing a solvent having an ester structure, a solvent having a carbonate structure and a hydroxyl group-containing solvent, the mixed solvent preferably contains from 30 to 80 mass% of the solvent having an ester structure, from 1 to 20 mass% of the solvent having a carbonate structure, and from 10 to 60 mass% of the hydroxyl group-containing solvent.

In a more preferred embodiment of the solvent, the solvent is a solvent containing an alkylene glycol monoalkyl ether carboxylate (preferably propylene glycol monomethyl ether acetate), more preferably a mixed solvent of an alkylene glycol monoalkyl ether carboxylate with another solvent, still more preferably a mixed solvent where the another solvent is at least one solvent having a functional group selected from a hydroxyl group, a ketone group, a lactone group, an ester group, an ether group and a carbonate group, or having a plurality of functional groups selected therefrom in combination. The particularly preferable mixed solvent is a mixed solvent of at least one member selected from ethyl lactate, γ-butyrolactone, propylene glycol monomethyl ether, butyl acetate and cyclohexanone, with propylene glycol monomethyl ether acetate. By selecting the particularly preferably mixed solvent, the development defect performance can be improved.

The mixing ratio between the alkylene glycol monoalkyl ether carboxylate and another solvent is, in terms of the mass ratio (alkylene glycol monoalkyl ether carboxylate/another solvent), from 95/5 to 30/70, preferably from 95/5 to 40/60, more preferably from 80/20 to 50/50. By increasing the proportion of the alkylene glycol monoalkyl ether carboxylate, the change of performance in aging after coating to exposure can be reduced.

The solid content concentration in the positive photosensitive composition of the present invention is preferably from 3 to 15 mass%, more preferably from 4 to 10 mass%, still more preferably from 5 to 8 mass%.

### [6] (E) Dissolution inhibiting compound having a molecular weight of 3,000 or less, which decomposes under the action of an acid to increase the solubility in an alkali developer

The positive photosensitive composition of the present invention may comprise a dissolution inhibiting compound having a molecular weight of 3,000 or less, which decomposes under the action of an acid to increase the solubility in an alkali developer (hereinafter sometimes referred to as a "dissolution inhibiting compound").

In order to prevent reduction in the transparency to light at 220 nm or less, the dissolution inhibiting compound is preferably an alicyclic or aliphatic compound having an acid-decomposable group, such as acid-decomposable group-containing cholic acid derivatives described in Proceeding of SPIE, 2724, 355 (1996). Examples of the acid-decomposable group and alicyclic structure are the same as those described above for the resin of the component (A).

The molecular weight of the dissolution inhibiting compound is 3,000 or less, preferably from 300 to 3,000, more preferably from 500 to 2,500.

The amount of the dissolution inhibiting compound added is preferably from 3 to 50 mass%, more preferably from 5 to 40 mass%, based on the solid content of the positive photosensitive composition.

Specific examples of the dissolution inhibiting compound are set forth below, but the present invention is not limited thereto.

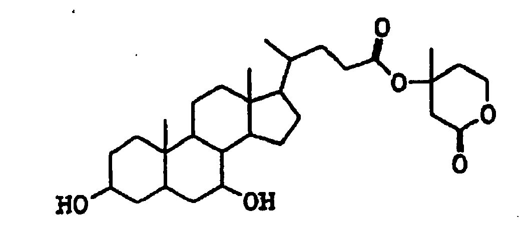

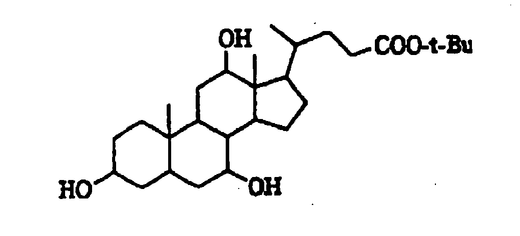

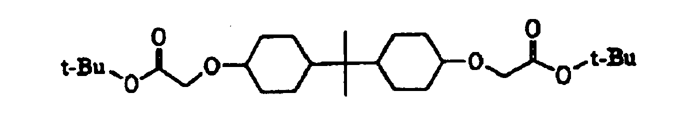

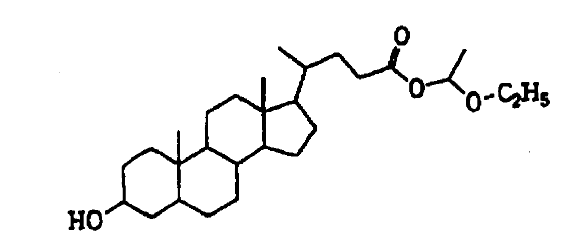

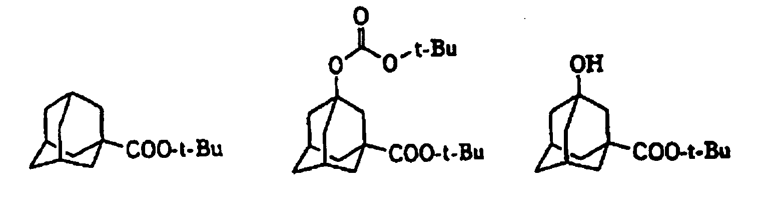

### [7] (F) Basic compound

The positive photosensitive composition of the present invention preferably contains a basic compound for reducing the change of performance in aging from exposure to heating or for controlling the in-film diffusion of the acid generated upon exposure.

The basic compound includes a nitrogen-containing basic compound and an onium salt compound.

The preferred nitrogen-containing basic compound includes compounds having a partial structure represented by the following formulae (A) to (E).

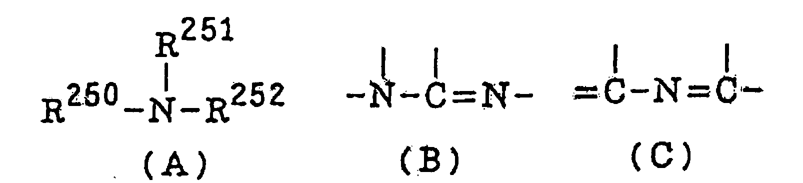

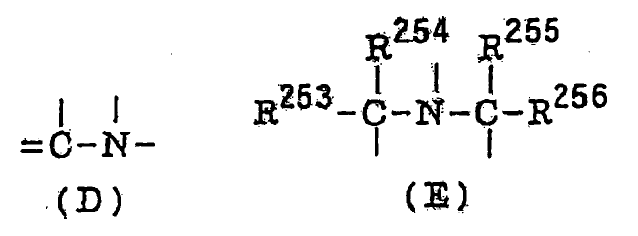

In formula (A), R²⁵⁰, R²⁵¹ and R²⁵² each independently represents a hydrogen atom, an alkyl group having a carbon number of 1 to 20, a cycloalkyl group having a carbon number of 3 to 20, or an aryl group having a carbon number of 6 to 20, and R²⁵⁰ and R²⁵¹ may combine with each other to form a ring. These groups each may have a substituent. The alkyl or cycloalkyl group having a substituent is preferably an aminoalkyl group having a carbon number of 1 to 20, an aminocycloalkyl group having a carbon number of 3 to 20, a hydroxyalkyl group having a carbon number of 1 to 20, or a hydroxycycloalkyl group having a carbon number of 3 to 20. The alkyl chain thereof may contain an oxygen atom, a sulfur atom or a nitrogen atom.

In formula (E), R²⁵³, R²⁵⁴, R²⁵⁵ and R²⁵⁶ each independently represents an alkyl group having a carbon number of 1 to 6 or a cycloalkyl group having a carbon number of 3 to 6.

Preferred examples of the compound include guanidine, aminopyrrolidine, pyrazole, pyrazoline, piperazine, aminomorpholine, aminoalkylmorpholine and piperidine, and these compounds each may have a substituent. Among these compounds, more preferred are a compound having an imidazole structure, a diazabicyclo structure, an onium hydroxide structure, an onium carboxylate structure, a trialkylamine structure, an aniline structure or a pyridine structure; an alkylamine derivative having a hydroxyl group and/or an ether bond; and an aniline derivative having a hydroxyl group and/or an ether bond.

Examples of the compound having an imidazole structure include imidazole, 2,4,5-triphenylimidazole and benzimidazole. Examples of the compound having a diazabicyclo structure include 1,4-diazabicyclo[2,2,2]octane, 1,5-diazabicyclo[4,3,0]non-5-ene and 1,8-diazabicyclo-[5,4,0]undec-7-ene. Examples of the compound having an onium hydroxide structure include a triarylsulfonium hydroxide, a phenacylsulfonium hydroxide and a sulfonium hydroxide having a 2-oxoalkyl group, specifically, triphenylsulfonium hydroxide, tris(tert-butylphenyl)sulfonium hydroxide, bis(tert-butylphenyl)iodonium hydroxide, phenacylthiophenium hydroxide and 2-oxopropylthiophenium hydroxide. The compound having an onium carboxylate structure is a compound where the anion moiety of the compound having an onium hydroxide structure is converted into a carboxylate, and examples thereof include acetate, adamantane-1-carboxylate and perfluoroalkyl carboxylate. Examples of the compound having a trialkylamine structure include tri(n-butyl)amine and tri(n-octyl)amine. Examples of the aniline compound include 2,6-diisopropylaniline and N,N-dimethylaniline. Examples of the alkylamine derivative having a hydroxyl group and/or an ether bond include ethanolamine, diethanolamine, triethanolamine and tris-(methoxyethoxyethyl)amine. Examples of the aniline derivative having a hydroxyl group and/or an ether bond include N,N-bis(hydroxyethyl)aniline.

One of these basic compounds may be used alone, or two or more species thereof may be used. The amount of the basic compound used is usually from 0.001 to 10 mass%, preferably from 0.01 to 5 mass%, based on the solid content of the positive photosensitive composition. The amount used is preferably 0.001 mass% or more for obtaining a sufficiently high addition effect and preferably 10 mass% or less in view of sensitivity and developability of the unexposed area.

### [8] Other additives

If desired, the positive photosensitive composition of the present invention may further contain a dye, a plasticizer, a photosensitizer, a compound capable of accelerating the solubility in a developer, and the like.

The compound capable of accelerating the dissolution in a developer, which can be used in the present invention, is a low molecular compound containing two or more phenolic OH groups or one or more carboxy group and having a molecular weight of 1,000 or less. In the case of containing a carboxyl group, an alicyclic or aliphatic compound is preferred.

The amount of the dissolution accelerating compound added is preferably from 2 to 50 mass%, more preferably from 5 to 30 mass%, based on the total amount of the resin. The amount added is preferably 50 mass% or less from the standpoint of suppressing the development residue or preventing the deformation of pattern at the development.

The phenol compound having a molecular weight of 1,000 or less can be easily synthesized by one skilled in the art with reference to the method described, for example, in JP-A-4-122938, JP-A-2-28531, U.S. Patent 4,916,210 and European Patent 219294.

Specific examples of the alicyclic or aliphatic compound having a carboxy group include, but are not limited to, a carboxylic acid derivative having a steroid structure, such as cholic acid, deoxycholic acid and lithocholic acid, an adamantane carboxylic acid derivative, an adamantane dicarboxylic acid, a cyclohexanecarboxylic acid and a cyclohexanedicarboxylic acid.

### [9] Pattern forming method

The positive photosensitive composition of the present invention is used by dissolving the above-described components in a predetermined organic solvent, preferably in a mixed solvent described above, filtering the resulting solution through a filter, and coating the obtained solution on a predetermined support as follows. The filter for use in the filtering is preferably a filter made of polytetrafluoroethylene, polyethylene or nylon and having a pore size of 0.1 µmor less, more preferably 0.05 µm or less, still more preferably 0.03 µm or less.

For example, the positive photosensitive composition is coated on a substrate (e.g., silicon/silicon dioxide-coated substrate) as used in the production of a precision integrated circuit device, by an appropriate coating method such as spinner or coater, and dried to form a photosensitive film. If desired, a known antireflection film may be previously provided by coating.

The thickness of the photosensitive film formed is preferably from 50 to 300 nm, more preferably from 70 to 200 nm, still more preferably from 80 to 150 nm. With a smaller film thickness, the effect of the positive photosensitive composition of the present invention becomes prominent.

The photosensitive film formed is irradiated with actinic rays or radiation through a predetermined mask and preferably after baking (heating), subjected to development and rinsing, whereby a good pattern can be obtained.

At the irradiation with actinic rays or radiation, the exposure may be performed by filling a liquid (immersion medium) having a refractive index higher than that of air between the photosensitive film and the lens (immersion exposure). By this exposure, the resolution can be enhanced. The immersion medium used may be any liquid as long as it has a refractive index higher than that of air, but pure water is preferred. Also, an overcoat layer may be further provided on the photosensitive film so as to prevent the immersion medium from coming into direct contact with the photosensitive film at the immersion exposure. By virtue of this overcoat layer, dissolving out of the composition from the photosensitive film into the immersion medium can be suppressed and the development defect can be reduced.

Examples of the actinic ray or radiation include infrared light, visible light, ultraviolet light, far ultraviolet light, X-ray and electron beam. Among these, preferred is far ultraviolet light at a wavelength of 250 nm or less, more preferably 220 nm or less. Specifically, a KrF excimer laser (248 nm), an ArF excimer laser (193 nm), an F₂ excimer laser (157 nm), an X-ray, an electron beam and the like are used, and an ArF excimer laser, an F₂ excimer laser, EUV (13 nm) and an electron beam are preferred.

In the development step, an alkali developer is used as follows. The alkali developer usable for the resist composition is an alkaline aqueous solution of inorganic alkalis such as sodium hydroxide, potassium hydroxide, sodium carbonate, sodium silicate, sodium metasilicate and aqueous ammonia, primary amines such as ethylamine and n-propylamine, secondary amines such as diethylamine and din-butylamine, tertiary amines such as triethylamine and methyldiethylamine, alcohol amines such as dimethylethanolamine and triethanolamine, a quaternary ammonium salt such as tetramethylammonium hydroxide and tetraethylammonium hydroxide, or cyclic amines such as pyrrole and piperidine.

In the alkali developer, alcohols and a surfactant may also be added in an appropriate amount.

The alkali concentration of the alkali developer is usually from 0.1 to 20 mass%.

The pH of the alkali developer is usually from 10.0 to 15.0.

### EXAMPLES

The present invention is described in greater detail below by referring to Examples, but the present invention should not be construed as being limited thereto.

### Synthesis Example 1 (Synthesis of Monomer (A))

Hydroxydiamantane (9.8 g), 3.7 g of methacrylic anhydride and 0.5 g of concentrated sulfuric acid were dissolved in 150 ml of toluene and reacted under reflux conditions for 2 hours. The reaction solution was washed with an aqueous sodium hydrogencarbonate solution and then with distilled water, dried over anhydrous sodium sulfate and concentrated to obtain a crude product. This crude product was purified by column chromatography, as a result, 6.3 g of Monomer (A) was obtained.

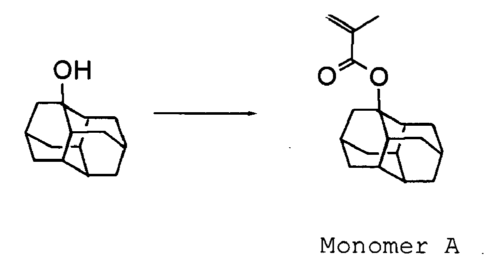

### Synthesis Example 2 (Synthesis of Monomer (B)):

Bromine (160 ml) was cooled to -7°C, and 40 g of diamantane was gradually added thereto while keeping the reaction solution temperature at -3°C or less. Thereafter, 2.16 g of aluminum bromide was gradually added while keeping the reaction solution temperature at 0°C or less. After stirring at -7°C for 30 minutes, the resulting reaction solution was gently poured in a solution containing 500 g of sodium sulfite, 160 g of sodium hydroxide and 3 L of water. The precipitate was collected by filtration and washed with acetonitrile to obtain 63 g of dibromodiamantane.

Subsequently, 80 ml of concentrated nitric acid was gently added to 20 g of dibromodiamantane and reacted under heating at 70°C for 30 minutes. The obtained reaction solution was poured in 300 ml of water and then rendered alkaline by adding 72 g of sodium hydroxide/500 ml of water. The precipitate was collected by filtration and washed with water to obtain 7 g of dihydroxydiamantane.

Using this dihydroxydiamantane, 3 g of Monomer (B) was obtained in the same manner as in the synthesis of Monomer (A).

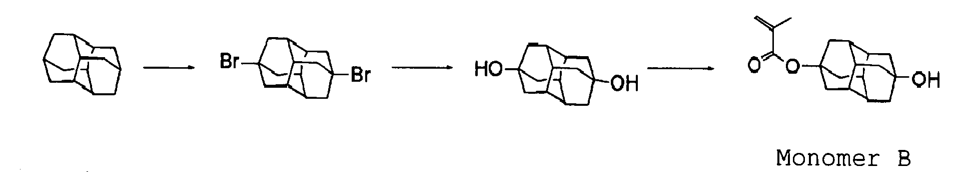

### Synthesis Example 3 (Synthesis of Resin (RA-1) (dropping polymerization)):

In a nitrogen stream, 5.1 g of propylene glycol monomethyl ether acetate and 3.4 g of propylene glycol monomethyl ether were changed into a three-necked flask, and the flask was heated to 80°C. Thereto, a solution prepared by dissolving 2.7 g of Monomer (A), 4.7 g of 3-hydroxyadamantane methacrylate, 7.0 g of 2-methyl-2-adamantyl methacrylate, 6.8 g of γ-butyrolactone methacrylate, and initiator V-601 (produced by Wako Pure Chemical Industries, Ltd.) in an amount of 4 mol% based on the monomer, in 46 g of propylene glycol monomethyl ether acetate and 30.7 g of propylene glycol monomethyl ether, was added dropwise. After the completion of dropwise addition, the reaction was further allowed to proceed at 80°C for 2 hours. The resulting reaction solution was allowed to cool and then poured in 720 ml of hexane/80 ml of ethyl acetate, and the precipitated powder was collected by filtration and dried to obtain 18 g of Resin (RA-1). The obtained resin had a weight average molecular weight of 10,700 in terms of polystyrene by the GPC method and a dispersity (Mw/Mn) of 1.81.

Resins (RA-2) to (RA-18) were synthesized in the same manner.

### Synthesis Example 4 (Synthesis of Resin (RA-1') (dropping polymerization)):

Resin (RA-1') having the same structure as Resin (RA-1) was obtained by performing the same operation as in Synthesis Example 3 except for changing the amount of initiator V-601 (produced by Wako Pure Chemical Industries, Ltd.) to 1 mol% based on the monomer in Synthesis Example 3. The obtained Resin (RA-1') had a weight average molecular weight of 33,600 in terms of polystyrene by the GPC method and a dispersity (Mw/Mn) of 2.6.

### Synthesis Example 5 (Synthesis of Resin (RA-1") (batch polymerization)):

In a nitrogen stream, 2.7 g of Monomer (A), 4.7 g of 3-hydroxyadamantane methacrylate, 7.0 g of 2-methyl-2-adamantyl methacrylate and 6.8 g of γ-butyrolactone methacrylate were dissolved in 51 g of propylene glycol monomethyl ether acetate and 34 g of propylene glycol monomethyl ether. The resulting solution was heated to 80°C and after adding thereto initiator V-601 (produced by Wako Pure Chemical Industries, Ltd.) in an amount of 3 mol% based on the monomer, the reaction was allowed to proceed at 80°C for 5 hours. The resulting reaction solution was allowed to cool and then poured in 720 ml of hexane/80 ml of ethyl acetate, and the precipitated powder was collected by filtration and dried to obtain 17 g of Resin (RA-1") having the same structure as Resin (RA-1). The obtained Resin (RA-1") had a weight average molecular weight of 35,200 in terms of polystyrene by the GPC method and a dispersity (Mw/Mn) of 3.6.

The structure, compositional ratio, weight average molecular weight and dispersity of each of Resins (RA-1) to (RA-18) are shown below.

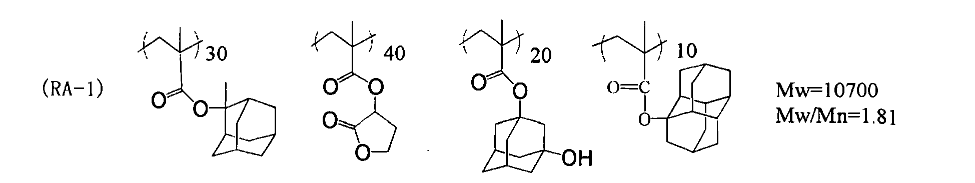

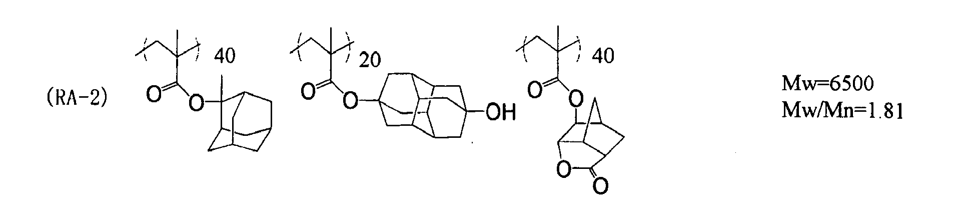

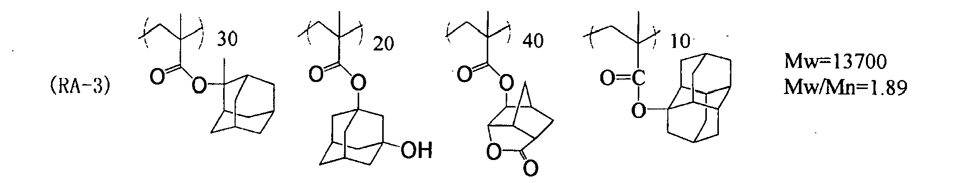

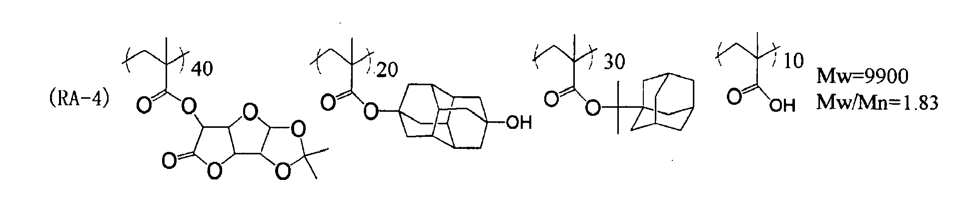

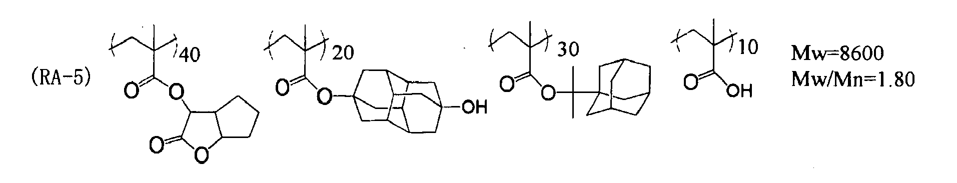

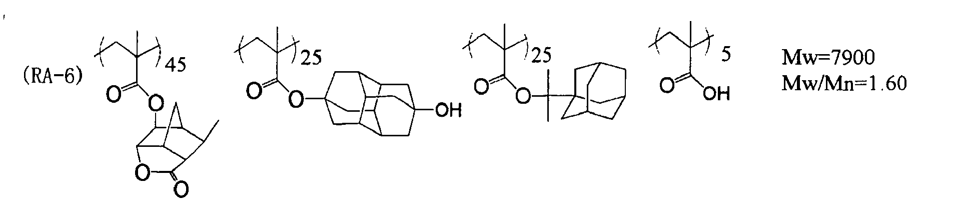

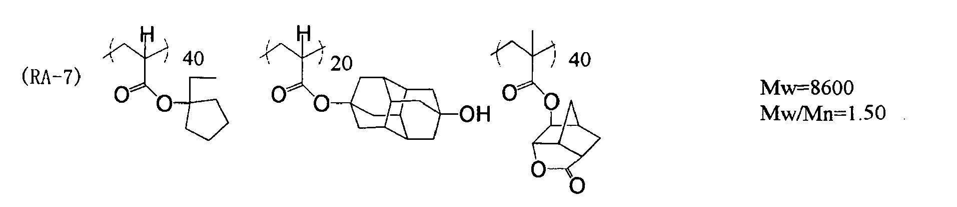

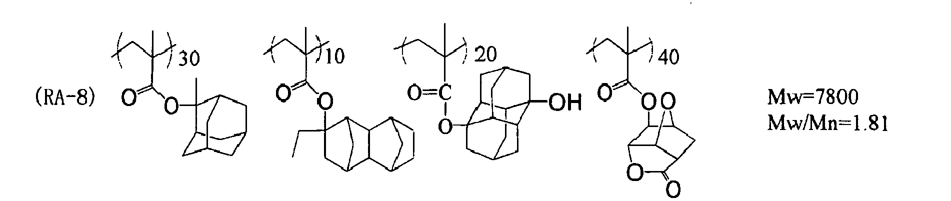

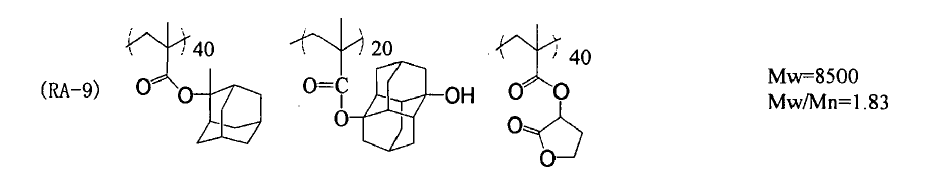

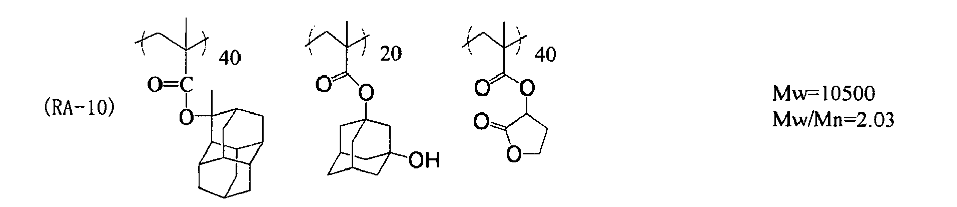

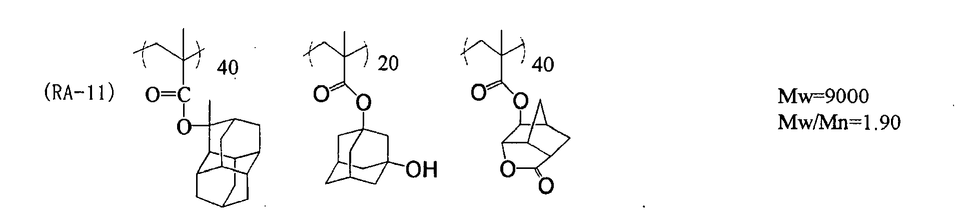

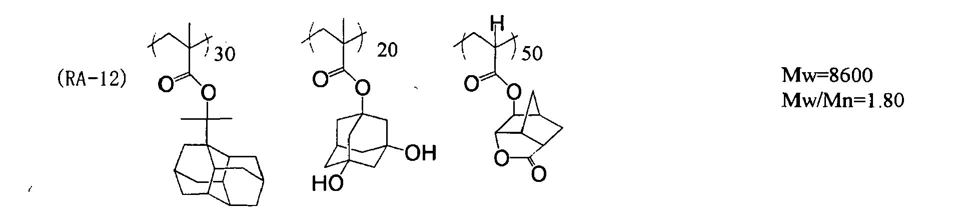

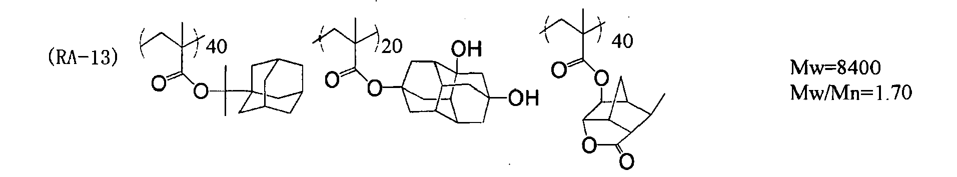

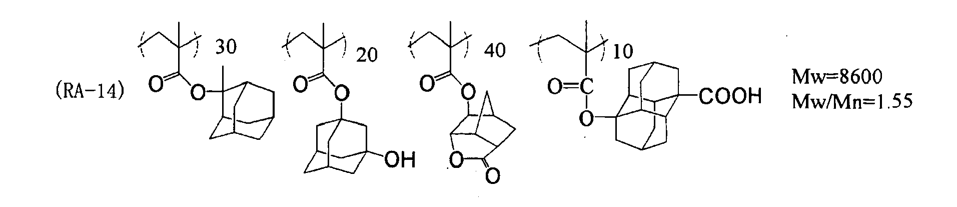

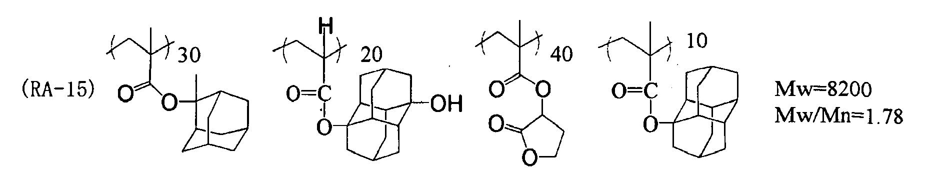

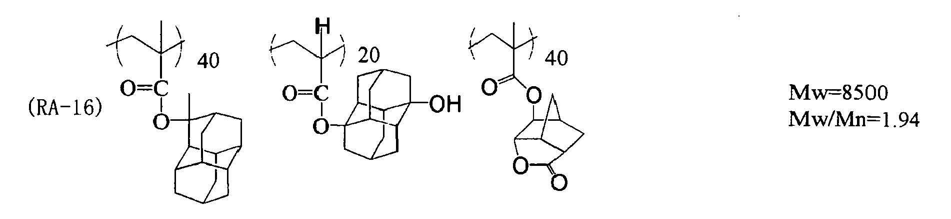

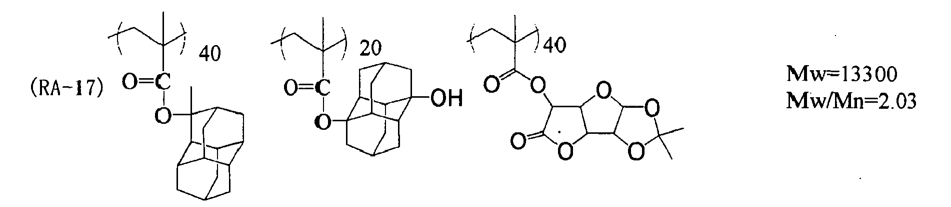

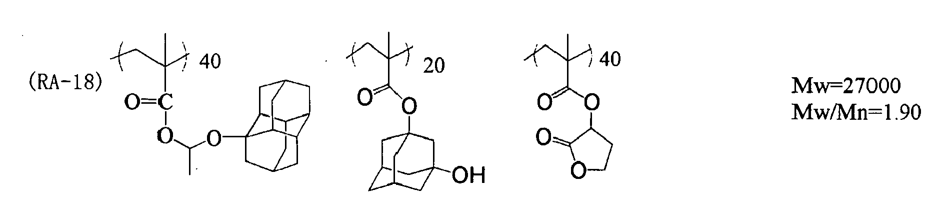

### Examples 1 to 18 and Comparative Examples 1 and 2:

The components shown in Table 1 below were dissolved in a solvent to prepare a solution having a solid content concentration of 8 mass%, and this solution was filtered through a 0.05 µm polyethylene filter to prepare a positive resist solution. The prepared positive resist solution was evaluated by the following methods. The results are shown in Table 1.

**Table 1**

| Example | Acid Generator (0.06 g) | Resin (2 g) | Basic Compound (4 mg) | Surfactant (0.1 mg) | Solvent | Dark·Bright Difference (nm) |
|---|---|---|---|---|---|---|
| Example 1 | Z1 | RA-3 | N-1 | W-4 | S1/S4=95/5 | 1.0 |
| Example 2 | Z7 | RA-6 | N-9 | W-2 | S1/S6=80/20 | 0.3 |
| Example 3 | Z5 | RA-8 | N-8 | W-3 | S1/S5=80/20 | 1.4 |
| Example 4 | Z4 | RA-17 | N-2 | W-3 | S1/S3=60/40 | 0.8 |
| Example 5 | Z1 | RA-18 | N-5 | W-1 | S1/S5/S7=70/28/2 | 1.1 |
| Example 6 | Z7/Z2 = 5/5 | RA-10 | N-4 | W-3 | S1/S2=80/20 | 0.4 |
| Example 7 | Z4/Z36 = 9/1 | RA-1 | N-6 | W-4 | S1/S6=70/30 | 0.9 |
| Example 8 | Z5/Z56 = 8/2 | RA-15 | N-3 | W-1 | S1/S5=60/40 | 1.3 |
| Example 9 | Z1/Z2 = 6/4 | RA-9 | N-2/N-7=7/3 | W-4/W-5=8/2 | S1/S4=95/5 | 1.1 |
| Example 10 | Z43/Z1 = 7/3 | RA-7 | N-8 | W-3 | S1/S3=60/40 | 0.2 |
| Example 11 | Z3 | RA-13 | N-8 | W-1 | S1/S5/S7=70/28/2 | 0.6 |
| Example 12 | Z30 | RA-16 | N-10 | W-3 | S1/S6=70/30 | 1.2 |
| Example 13 | Z2 | RA-4 | N-9 | W-2 | S1/S4=95/5 | 0.8 |
| Example 14 | Z1 | RA-12 | N-6 | W-3/W-6=9/1 | S1/S5=80/20 | 0.7 |
| Example 15 | Z1/Z56 = 5/5 | RA-14 | N-2 | W-4 | S1/S3=60/40 | 1.3 |
| Example 16 | Z3/Z55 = 6/4 | RA-11 | N-4 | W-2 | S1/S6=80/20 | 0.5 |
| Example 17 | Z3/Z1 = 8/2 | RA-5 | N-3 | W-4 | S1/S3=60/40 | 1.3 |
| Comparative Example 1 | z1 | RA-1' | N-8 | W-5 | S1/S4=95/5 | 9.7 |
| Comparative Example 2 | z2 | RA-1" | N-4 | W-6 | S1/S5=60/40 | 8.3 |

As for each component, in the case of using a plurality of species, the ratio is a ratio by mass.

The abbreviations in the Table indicate the followings.

### [Basic Compound]

N-1: 2,4,5-triphenylimidazole
N-2: 2-phenylbenzimidazole
N-3: triphenylsulfonium acetate
N-4: 2,6-diisopropylaniline
N-5: dicyclohexylmethylamine
N-6: tripentylamine
N-7: hydroxyantipyrine
N-8: tetrabutylammonium hydroxide
N-9: tris(methoxyethoxyethyl)amine
N-10: N-phenyldiethanolamine

### [Surfactant]

W-1: PF636 (produced by OMNOVA) (fluorine-containing)
W-2: PF6320 (produced by OMNOVA) (fluorine-containing)
W-3: PF656 (produced by OMNOVA) (fluorine-containing)
W-4: PF6520 (produced by OMNOVA) (fluorine-containing)
W-5: Megafac F176 (produced by Dainippon Ink & Chemicals, Inc.) (fluorine-containing)
W-6: Florad FC430 (produced by Sumitomo 3M Inc.) (fluorine-containing)

The structures of PF636, PF6320, PF656 and PF6520 are shown below.

| | |
|---|---|
| PF636 | 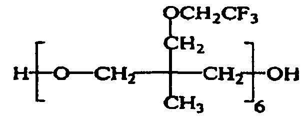 |
| PF6320 | 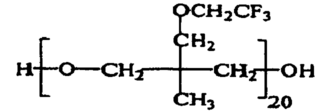 |
| PF656 | 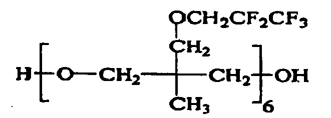 |
| PF6520 | 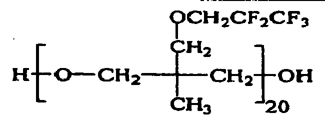 |

### [Solvent]

S1: propylene glycol methyl ether acetate
S2: 2-heptanone
S3: cyclohexanone
S4: γ-butyrolactone
S5: propylene glycol methyl ether
S6: ethyl lactate
S7: propylene carbonate

### <Evaluation of Resist>

An antireflection film ARC-29A produced by Brewer Science Co., Ltd. was coated on a silicon substrate by a spin coater to a thickness of 780 angstrom (78 nm) and dried under heating at 205°C for 60 seconds. Thereafter, each positive resist solution was coated by a spin coater and dried at 110°C for 60 seconds to form a resist film of 180 nm. This resist film was pattern-exposed through a halftone phase-shift mask with a transmittance of 6% by using an ArF excimer laser stepper (manufactured by ASML, NA=0.75, 2/3 annular illumination) and then heated on a hot plate at 120°C for 60 seconds. Furthermore, the resulting resist film was developed with an aqueous 2.38 mass% tetramethylammonium hydroxide solution (at 23°C) for 30 seconds, rinsed with pure water for 30 seconds and then spin-dried to obtain a resist pattern.

### [Evaluation Method of Dark·Bright Difference]

The resist pattern used for the evaluation was a dense pattern comprising a 30-nm line at a line/space ratio of 1:1 (pitch: 180 nm). At this time, the exposure mask used for transferring this line pattern had both a Bright Field Mask region and a Dark Field Mask region. The exposure amount (Eopt) for reproducing the mask size of the Bright Field Mask (A in Fig. 1) was determined by the length-measuring scanning electron microscope (S-9260) manufactured by Hitachi Ltd. and furthermore, the finish size (CD1) of the Dark Field Mask (B in Fig. 1) at the Eopt was measured. In Fig. 1, the white portion indicates the light passing portion.

The difference between the finish size with the Dark Field Mask and the finish size with the Bright Field Mask is defined as the Dark·Bright difference. As the numerical value is smaller, the performance is higher.

As seen from Table 1, the positive photosensitive composition of the present invention is assured of small Dark·Bright difference and excellent performance.

This application is based on Japanese Patent application JP 2005-278297, filed September 26, 2005.

## Claims

1. A positive photosensitive composition comprising:
a resin which comprises a repeating unit having a diamantane structure and decomposes under an action of an acid to increase a solubility in an alkali developer;
a compound capable of generating an acid upon irradiation with actinic rays or radiation;
a compound represented by the following formula (1); and
a solvent; 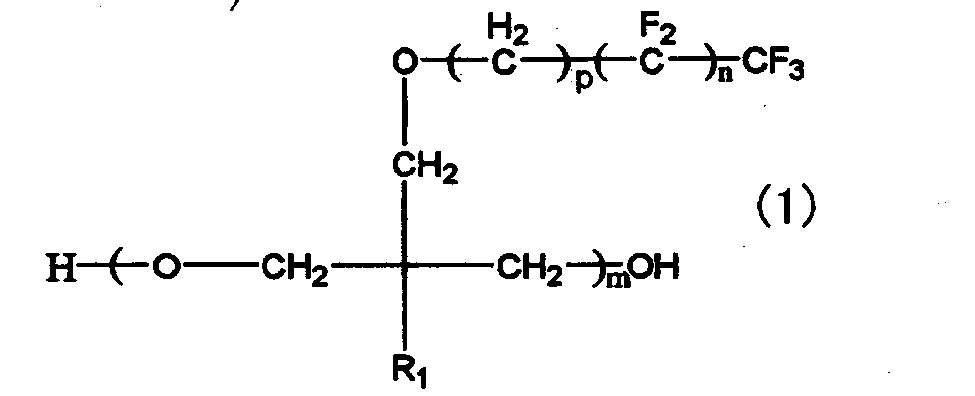
wherein R₁ represents a hydrogen atom or an alkyl group, m represents an integer of from 1 to 30, n represents an integer of from 0 to 3, and p represents an integer of from 0 to 5.

2. The positive photosensitive composition as claimed in claim 1, wherein the resin has a weight average molecular weight of from 3,000 to 30,000 and a dispersity of from 1.1 to 3.0.

3. The positive photosensitive composition as further comprises claimed in claim 1, wherein the resin a repeating unit having an adamantane structure.

4. The positive photosensitive composition as further comprises claimed in claim 1, wherein the resin a non-acid-decomposable repeating unit.

5. The positive photosensitive composition as claimed in claim 1, which comprises an alkylene glycol monoalkyl ether carboxylate as the solvent.

6. The positive photosensitive composition as claimed in claim 1, which comprises, as the solvent, an alkylene glycol monoalkyl ether carboxylate and a solvent having at least one functional group selected from the group consisting of a hydroxyl group, a ketone group, a lactone group, an ester group, and ether group and a carbonate group.

7. The positive photosensitive composition as claimed in claim 1, which comprises, as the solvent, propylene glycol monomethyl ether carboxylate and at least one solvent selected from propylene glycol monomethyl ether, cyclohexanone, γ-butyrolactone, butyl acetate and ethyl lactate.

8. The positive photosensitive composition as claimed in claim 1, wherein the resin is a resin synthesized by dropping polymerization.

9. A pattern forming method comprising: forming a photosensitive film from the positive photosensitive composition claimed in claim 1; exposing the photosensitive film; and developing the photosensitive film.

## Patentansprüche

1. Positive fotoempfindliche Zusammensetzung, umfassend:
ein Harz, das eine Wiederholungseinheit umfaßt, die eine Diamantanstruktur aufweist, und das sich unter der Wirkung einer Säure zersetzt, um die Löslichkeit in einem Alkalientwickler zu erhöhen;
eine Verbindung, die bei der Bestrahlung mit aktinischen Strahlen oder Strahlung eine Säure bilden kann;
eine durch die folgende Formel (1) dargestellte Verbindung; und
ein Lösungsmittel, 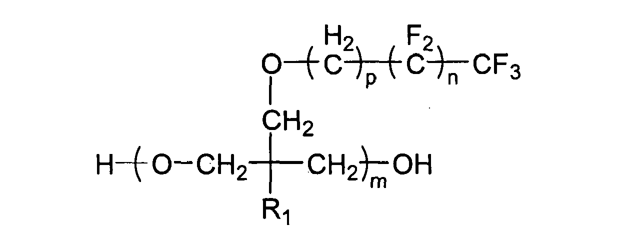
worin R₁ ein Wasserstoffatom oder eine Alkylgruppe darstellt, m eine ganze Zahl von 1 bis 30 darstellt, n eine ganze Zahl von 0 bis 3 darstellt und p eine ganze Zahl von 0 bis 5 darstellt.

2. Positive fotoempfindliche Zusammensetzung gemäß Anspruch 1, worin das Harz ein gewichtsgemitteltes Molekulargewicht von 3.000 bis 30.000 und einen Dispersionsgrad von 1,1 bis 3,0 aufweist.

3. Positive fotoempfindliche Zusammensetzung gemäß Anspruch 1, worin das Harz ferner eine Wiederholungseinheit, die eine Adamantanstruktur aufweist, umfaßt.

4. Positive fotoempfindliche Zusammensetzung gemäß Anspruch 1, worin das Harz ferner eine nicht-säurezersetzbare Wiederholungseinheit umfaßt.

5. Positive fotoempfindliche Zusammensetzung gemäß Anspruch 1, die als Lösungsmittel ein Alkylenglycolmonoalkylethercarboxylat umfaßt.

6. Positive fotoempfindliche Zusammensetzung gemäß Anspruch 1, die als Lösungsmittel ein Alkylenglycolmonoalkylethercarboxylat und ein Lösungsmittel umfaßt, welches zumindest eine funktionelle Gruppe aufweist, ausgewählt aus der Gruppe bestehend aus einer Hydroxylgruppe, einer Ketongruppe, einer Lactongruppe, einer Estergruppe und Ethergruppe und einer Carbonatgruppe.

7. Positive fotoempfindliche Zusammensetzung gemäß Anspruch 1, die als Lösungsmittel Propylenglycolmonomethylethercarboxylat und zumindest ein Lösungsmittel umfaßt, das ausgewählt ist aus Propylenglycolmonomethylether, Cyclohexanon, γ-Butyrolacton, Butylacetat und Ethyllactat.

8. Positive fotoempfindliche Zusammensetzung gemäß Anspruch 1, worin das Harz ein Harz ist, das durch Tropfpolymerisation synthetisiert ist.

9. Musterbildungsverfahren, umfassend: Bilden eines fotoempfindlichen Films aus der positiven fotoempfindlichen Zusammensetzung gemäß Anspruch 1; Belichten des fotoempfindlichen Films; und Entwickeln des fotoempfindlichen Films.

## Revendications

1. Composition photosensible positive, comprenant :
une résine qui comprend une unité récurrente ayant une structure diamantane et qui se décompose sous l'action d'un acide pour augmenter la solubilité dans un agent de développement alcalin ;
un composé capable de générer un acide par irradiation par des rayons actiniques ou radiation ;
un composé représenté par la formule (1) suivante, et
un solvant, 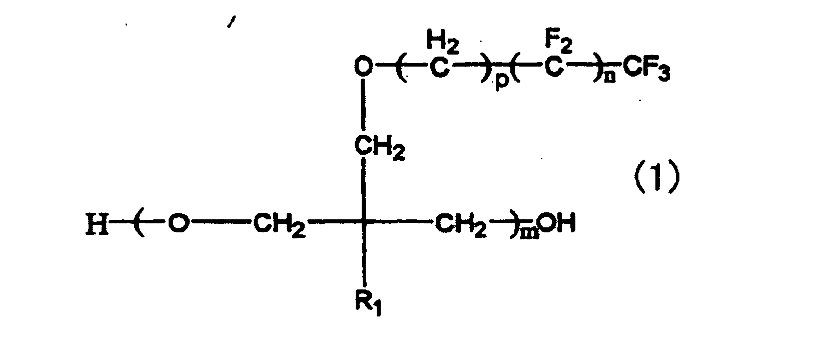
où R₁ représente un atome d'hydrogène ou un radical alkyle, m représente un entier allant de 1 à 30, n représente un entier allant de 0 à 3, et p représente un entier allant de 0 à 5.

2. Composition photosensible positive selon la revendication 1, où la résine a un poids moléculaire moyen en poids allant de 3000 à 30 000 et une dispersité allant de 1,1 à 3,0.

3. Composition photosensible positive selon la revendication 1, où la résine comprend en outre, une unité récurrente ayant une structure adamantane.

4. Composition photosensible positive selon la revendication 1, où la résine comprend en outre, une unité récurrente non décomposable par un acide.

5. Composition photosensible positive selon la revendication 1, qui comprend un carboxylate d'alkylèneglycolmonoalkyléther comme solvant.

6. Composition photosensible positive selon la revendication 1, qui comprend comme solvant, un carboxylate d'alkylèneglycolmonoalkyléther et un solvant ayant au moins un groupe fonctionnel choisi parmi le groupe consistant en un radical hydroxyle, un radical cétone, un radical lactone, un radical ester et un radical éther et un radical carbonate.

7. Composition photosensible positive selon la revendication 1, qui comprend comme solvant, le carboxylate de propylèneglycolmonométhyléther et au moins un solvant choisi parmi le propylèneglycolmonométhyléther, la cyclohexanone, la γ-butyrolactone, l'acétate de butyle et le lactate d'éthyle.

8. Composition photosensible positive selon la revendication 1, où la résine est une résine synthétisée par polymérisation au goutte à goutte.

9. Procédé de formation de motif comprenant : la formation d'un film photosensible à partir de la composition photosensible positive selon la revendication 1, l'exposition du film photosensible, et le développement du film photosensible.
